(19) Europäisches Patentamt
European Patent Office
Office européen des brevets

(11) **EP 4 675 606 A1**

(12) **EUROPEAN PATENT APPLICATION**
published in accordance with Art. 153(4) EPC

(43) Date of publication:
**07.01.2026 Bulletin 2026/02**

(21) Application number: **24858051.6**

(22) Date of filing: **05.07.2024**

(51) International Patent Classification (IPC):
*G09G 3/34* (2006.01)      *G09G 3/32* (2016.01)
*G09F 9/33* (2006.01)      *G02F 1/13357* (2006.01)

(52) Cooperative Patent Classification (CPC):
**G02F 1/1336; G09F 9/33; G09G 3/32;**
**G09G 3/3208; G09G 3/3275; G09G 3/3291;**
**G09G 3/34**

(86) International application number:
**PCT/CN2024/103891**

(87) International publication number:
**WO 2025/044507 (06.03.2025 Gazette 2025/10)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **29.08.2023 CN 202311101816**

(71) Applicant: **Boe Technology Group Co., Ltd.**
**Beijing 100015 (CN)**

(72) Inventors:
• **ZHANG, Hao**
  **Beijing 100176 (CN)**
• **FENG, Yu**
  **Beijing 100176 (CN)**
• **HSIEH, Mingche**
  **Beijing 100176 (CN)**
• **LIU, Hao**
  **Beijing 100176 (CN)**
• **LIU, Libin**
  **Beijing 100176 (CN)**

(74) Representative: **Cohausz & Florack**
**Patent- & Rechtsanwälte**
**Partnerschaftsgesellschaft mbB**
**Bleichstraße 14**
**40211 Düsseldorf (DE)**

(54) **PIXEL DRIVING CIRCUIT AND DRIVING METHOD THEREFOR, AND DISPLAY PANEL**

(57)    A pixel driving circuit, a driving method for the pixel driving circuit and a display panel are provided. The pixel driving circuit includes: a driving transistor, a first reset sub-circuit, a second reset sub-circuit, a luminescent control sub-circuit, a data writing sub-circuit, a gating sub-circuit and an energy storage element. The first reset sub-circuit is configured to write a first initialization voltage signal to a control electrode of the driving transistor in response to a first reset signal; the second reset sub-circuit is configured to write a second initialization voltage signal to a first electrode of at least one light-emitting device in response to a second reset signal; the luminescent control sub-circuit is configured to electrically connect a first power supply line to the first electrode of the driving transistor in response to one of a first luminescent control signal and a second luminescent control signal; and the gating sub-circuit is configured to electrically connect a second electrode of the driving transistor to different light-emitting devices in response to different luminescent control signals.

FIG. 2

EP 4 675 606 A1

**Description**

TECHNICAL FIELD

The present disclosure relates to the field of display technology, and in particular to a pixel driving circuit, a driving method for the pixel driving circuit and a display panel.

BACKGROUND

An organic light-emitting diode (OLED) display has characteristics of self-luminescence, a wide viewing angle, a short response time, a high luminescent efficiency, a wide color gamut, a low operating voltage, thinness and the like, and therefore, becomes a very popular emerging flat panel display product at home and abroad. In the OLED display, a pixel driving circuit provides a driving current to a light-emitting device to drive the light-emitting device to emit light.

SUMMARY

In a first aspect, the present disclosure provides a pixel driving circuit, including: a driving transistor, a first reset sub-circuit, a second reset sub-circuit, a luminescent control sub-circuit, a data writing sub-circuit, a gating sub-circuit and an energy storage element; the energy storage element is connected between a control electrode and a first electrode of the driving transistor; the first reset sub-circuit is configured to write a first initialization voltage signal to the control electrode of the driving transistor in response to a first reset signal; the second reset sub-circuit is configured to write a second initialization voltage signal to a first electrode of at least one of a plurality of light-emitting devices in response to a second reset signal; the data writing sub-circuit is configured to write a data voltage signal and a threshold voltage signal of the driving transistor to the energy storage element in response to a scan signal; the luminescent control sub-circuit is configured to electrically connect a first power supply line to the first electrode of the driving transistor in response to one of a first luminescent control signal and a second luminescent control signal; and the gating sub-circuit is configured to electrically connect a second electrode of the driving transistor to different light-emitting devices in response to different luminescent control signals.

In some embodiments, the luminescent control sub-circuit includes a fifth transistor, a control electrode of the fifth transistor is electrically connected to a first luminescent control line, a first electrode of the fifth transistor is electrically connected to the first power supply line, and a second electrode of the fifth transistor is electrically connected to the first electrode of the driving transistor.

In some embodiments, the gating sub-circuit includes: a sixth transistor, an eighth transistor, and a ninth transistor, a control electrode of the sixth transistor is electrically connected to the first luminescent control line, and a first electrode of the sixth transistor is electrically connected to the second electrode of the driving transistor; a control electrode of the eighth transistor is electrically connected to a second luminescent control line, a first electrode of the eighth transistor is electrically connected to a second electrode of the sixth transistor, and a second electrode of the eighth transistor is electrically connected to a first light-emitting device; and a control electrode of the ninth transistor is electrically connected to a third luminescent control line, a first electrode of the ninth transistor is electrically connected to the second electrode of the sixth transistor, and a second electrode of the ninth transistor is electrically connected to a second light-emitting device.

In some embodiments, the luminescent control sub-circuit includes: a fifth transistor and a ninth transistor, a control electrode of the fifth transistor is electrically connected to a first luminescent control line, a first electrode of the fifth transistor is electrically connected to the first power supply line, and a second electrode of the fifth transistor is electrically connected to the first electrode of the driving transistor; and a control electrode of the ninth transistor is electrically connected to a second luminescent control line, a first electrode of the ninth transistor is electrically connected to the first power supply line, and a second electrode of the ninth transistor is electrically connected to the first electrode of the driving transistor.

In some embodiments, the gating sub-circuit includes: a sixth transistor and an eighth transistor; a control electrode of the sixth transistor is electrically connected to the first luminescent control line, a first electrode of the sixth transistor is electrically connected to the second electrode of the driving transistor, and a second electrode of the sixth transistor is electrically connected to a first light-emitting device; and a control electrode of the eighth transistor is electrically connected to the second luminescent control line, a first electrode of the eighth transistor is electrically connected to the second electrode of the driving transistor, and a second electrode of the eighth transistor is electrically connected to a second light-emitting device.

In some embodiments, the first reset sub-circuit includes: a first transistor, a control electrode of the first transistor is electrically connected to a first reset signal line, a first electrode of the first transistor is electrically connected to a first initialization voltage line, and a second electrode of the first transistor is electrically connected to the control electrode of the driving transistor.

In some embodiments, the second reset sub-circuit includes: a seventh transistor, a control electrode of the seventh transistor is electrically connected to a second reset signal line, a first electrode of the seventh transistor is electrically connected to a second initialization voltage line, and a second electrode of the seventh transistor is electrically connected to a first electrode of a first light-emitting device.

In some embodiments, the second reset sub-circuit further includes: a tenth transistor, a control electrode of the tenth transistor is electrically connected to the second reset signal line, a first electrode of the tenth transistor is electrically connected to the second initialization voltage line, and a second electrode of the tenth transistor is electrically connected to a first electrode of a second light-emitting device.

In some embodiments, the data writing sub-circuit includes: a fourth transistor and a second transistor; a control electrode of the fourth transistor is electrically connected to a scan line, a first electrode of the fourth transistor is electrically connected to a data line, and a second electrode of the fourth transistor is electrically connected to the first electrode of the driving transistor; and a control electrode of the second transistor is electrically connected to the scan line, a first electrode of the second transistor is electrically connected to the second electrode of the driving transistor, and a second electrode of the second transistor is electrically connected to the control electrode of the driving transistor.

In some embodiments, the energy storage element includes a storage capacitor including a first plate electrically connected to the control electrode of the driving transistor and a second plate electrically connected to the first electrode of the driving transistor.

In a second aspect, the present disclosure further provides a driving method for the pixel driving circuit in the first aspect, including a plurality of operating phases, in a reset sub-phase of each operating phase, the driving method includes writing, by the first reset sub-circuit, the first initialization voltage signal to the control electrode of the driving transistor in response to the first reset signal; in a data writing sub-phase of each operating phase, the driving method includes writing, by the second reset sub-circuit, the second initialization voltage signal to the first electrode of at least one of the plurality of light-emitting devices in response to the second reset signal; and writing, by the data writing sub-circuit, the data voltage signal and the threshold voltage signal of the driving transistor to the energy storage element in response to the scan signal; and in a luminescent sub-phase of each operating phases, the driving method includes electrically connecting, by the luminescent control sub-circuit, the first power supply line to the first electrode of the driving transistor in response to one of the first luminescent control signal and the second luminescent control signal; and in luminescent sub-phases of different operating phases, the driving method includes electrically connecting, by the gating sub-circuit, the second electrode of the driving transistor to different light-emitting devices in response to different luminescent control signals.

In a third aspect, the present disclosure further provides a display panel, including: a base substrate and a plurality of pixel driving circuits on the base substrate, each of the plurality of pixel driving circuits is electrically connected to a plurality of light-emitting devices, and each pixel driving circuit includes: a driving transistor, a luminescent control sub-circuit, and a gating sub-circuit; the luminescent control sub-circuit is configured to electrically connect a first power supply line to a first electrode of the driving transistor in response to one of a first luminescent control signal through a first luminescent control line and a second luminescent control signal through a second luminescent control line; and the gating sub-circuit is configured to electrically connect a second electrode of the driving transistor to different light-emitting devices in response to different luminescent control signals; the gating sub-circuit includes: an eighth transistor, a control electrode of the eighth transistor is electrically connected to the second luminescent control line, a second electrode of the eighth transistor is electrically connected to a first electrode of one of the plurality of light-emitting devices, and an orthographic projection of the eighth transistor on the base substrate and an orthographic projection of the driving transistor on the base substrate are on two opposite sides of an orthographic projection of the first luminescent control line on the base substrate, respectively.

In some embodiments, the display panel further includes: a first adapter electrode, a second adapter electrode and a third adapter electrode, a first electrode of one of the plurality of light-emitting devices connected to each pixel driving circuit is electrically connected to the first adapter electrode through a first via, the first adapter electrode is electrically connected to the second adapter electrode through a second via, the second adapter electrode is electrically connected to the third adapter electrode through a third via, and the third adapter electrode is electrically connected to the second electrode of the eighth transistor through a fourth via.

In some embodiments, the display panel includes a semiconductor layer, a first gate metal layer, a first source-drain metal layer, a second source-drain metal layer and a transparent conductive layer which are sequentially arranged in a direction away from the base substrate, the second electrode of the eighth transistor is in the semiconductor layer, the first luminescent control line and the second luminescent control line are in the first gate metal layer, the first adapter electrode is in the transparent conductive layer, the second adapter electrode is in the second source-drain metal layer, and the third adapter electrode is in the first source-drain metal layer.

In some embodiments, the plurality of light-emitting devices includes a first light-emitting device and a second light-emitting device, the second electrode of the eighth transistor is electrically connected to the first light-emitting device, and the gating sub-circuit further includes: a sixth transistor and a ninth transistor; a control electrode of the sixth transistor is electrically connected to the first luminescent control line, a first electrode of the sixth transistor is electrically connected to the second electrode of the driving transistor, and a second electrode of the sixth transistor is electrically connected to a first electrode of the eighth transistor; a control electrode of the ninth transistor is electrically connected to a third luminescent control line, a first electrode of the ninth transistor is electrically connected to the second electrode of the sixth transistor, and a second electrode of the ninth transistor is electrically connected to the second light-emitting device; and the first luminescent control line, the third luminescent control line and the second luminescent control line are arranged in the same layer and are sequentially arranged along a direction away from the driving transistor.

In some embodiments, the display panel further includes: a fourth adapter electrode electrically connected to the first electrode of the eighth transistor through a fifth via and electrically connected to the second electrode of the sixth transistor through a sixth via.

In some embodiments, the display panel includes a semiconductor layer, a first gate metal layer, and a first source-drain metal layer, which are sequentially arranged in a direction away from the base substrate, the first luminescent control line and the second luminescent control line are in the first gate metal layer, the first electrode of the eighth transistor and the second electrode of the sixth transistor are in the semiconductor layer, and the fourth adapter electrode is in the first source-drain metal layer.

In some embodiments, the display panel further includes: a fifth adapter electrode, a sixth adapter electrode and a seventh adapter electrode; a first electrode of the second light-emitting device is electrically connected to the fifth adapter electrode through a seventh via, the fifth adapter electrode is electrically connected to the sixth adapter electrode through an eighth via, the sixth adapter electrode is electrically connected to the seventh adapter electrode through a ninth via, and the seventh adapter electrode is electrically connected to the second electrode of the ninth transistor through a tenth via.

In some embodiments, each pixel driving circuit further includes a second reset sub-circuit including a seventh transistor, a control electrode of the seventh transistor is electrically connected to a second reset signal line, a first electrode of the seventh transistor is electrically connected to a second initialization voltage line, and a second electrode of the seventh transistor is electrically connected to a first electrode of the first light-emitting device.

In some embodiments, the display panel further includes: an eighth adapter electrode electrically connected to the first electrode of the seventh transistor through an eleventh via and electrically connected to the second initialization voltage line through a twelfth via.

In some embodiments, the second initialization voltage line extends in a first direction, and the display panel further includes: a second initialization voltage supply line extending in a second direction and electrically connected to the eighth adapter electrode through a thirteenth via; the plurality of pixel driving circuits are arranged in a plurality of columns along the first direction and in a plurality of rows along the second direction, and the display panel includes a plurality of the second initialization voltage supply lines arranged in the first direction; and a plurality of eighth adapter electrodes connected to pixel driving circuits in the same row include a plurality of first-type adapter electrodes and a plurality of second-type adapter electrodes, the plurality of first-type adapter electrodes are electrically connected to the corresponding second initialization voltage supply line, orthographic projections of the plurality of first-type adapter electrodes on the base substrate and an orthographic projection of the corresponding second initialization voltage supply line on the base substrate overlap with each other, orthographic projections of the plurality of second-type adapter electrodes on the base substrate and orthographic projections of the plurality of second initialization voltage supply lines on the base substrate do not overlap with each other, and at least one second-type adapter electrode is arranged between every two adjacent first-type adapter electrodes arranged along the first direction.

In some embodiments, the display panel includes a semiconductor layer, a first gate metal layer, a second gate metal layer, a first source-drain metal layer and a second source-drain metal layer, which are sequentially arranged in a direction away from the base substrate; the first electrode of the seventh transistor is in the semiconductor layer, the first luminescent control line and the second luminescent control line are in the first gate metal layer, the second initialization voltage line is in the second gate metal layer, the plurality of eighth adapter electrodes are in the first source-drain metal layer, and the plurality of second initialization voltage supply lines are in the second source-drain metal layer.

In some embodiments, the second reset sub-circuit further includes: a tenth transistor, a control electrode of the tenth transistor is electrically connected to the second reset signal line, a first electrode of the tenth transistor is electrically connected to the second initialization voltage line, and a second electrode of the tenth transistor is electrically connected to a first electrode of the second light-emitting device.

In some embodiments, the display panel further includes: a seventh adapter electrode electrically connected to the second electrode of the ninth transistor through a tenth via and electrically connected to the second electrode of the tenth transistor through a fourteenth via.

In some embodiments, the luminescent control sub-circuit includes: a fifth transistor, a control electrode of the fifth transistor is electrically connected to the first luminescent control line, a first electrode of the fifth transistor is electrically connected to the first power supply line, and a second electrode of the fifth transistor is electrically connected to the first electrode of the driving transistor.

In some embodiments, the first power supply line includes: a first power supply sub-line and a second power supply sub-line, the first power supply sub-line is electrically connected to the first electrode of the fifth transistor through a fifteenth via, and the second power supply sub-line is connected to the first power supply sub-line through a sixteenth via; and the display panel includes a plurality of first power supply sub-lines and a plurality of second power supply sub-lines, which are cross-connected to each other to form a mesh structure.

In some embodiments, each pixel driving circuit further includes a first reset sub-circuit including: a first transistor, a control electrode of the first transistor is electrically connected to a first reset signal line, a first electrode of the first transistor is electrically connected to a first initialization voltage line, and a second electrode of the first transistor is electrically connected to the control electrode of the driving transistor; the first transistor is on a side of the driving transistor away from the eighth transistor; each pixel driving circuit further includes a second reset sub-circuit including: a seventh transistor, and a control electrode of the seventh transistor is electrically connected to a second reset signal line; and the plurality of pixel driving circuits are arranged in a plurality of columns along a first direction and in a plurality of rows along a second direction, and in the pixel driving circuits in any two adjacent rows, the second reset signal line connected to the seventh transistors in the previous row and the first reset signal line in the next row have a one-piece structure.

In some embodiments, an active layer, the first electrode, and the second electrode of the first transistor are connected together so that the first transistor has an L-shaped structure, including a first extension portion extending in the first direction and a second extension portion extending in the second direction, at least a portion of the first electrode of the first transistor is on the first extension portion, and the second electrode of the first transistor is on the second extension portion.

In some embodiments, the display panel further includes: a ninth adapter electrode electrically connected to the first electrode of the first transistor through an eighteenth via and electrically connected to the first initialization voltage line through a nineteenth via.

In some embodiments, the first initialization voltage line extends in the first direction; and the display panel further includes: a first initialization voltage supply line extending in the second direction, the second direction intersects with the first direction, and the first initialization voltage supply line is electrically connected to the ninth adapter electrode through a twentieth via.

In some embodiments, the plurality of pixel driving circuits are arranged in the plurality of columns along the first direction and in the plurality of rows along the second direction, and the display panel includes a plurality of the first initialization voltage supply lines arranged in the first direction; and ninth adapter electrodes connected to pixel driving circuits in the same row include a plurality of third-type adapter electrodes and a plurality of fourth-type adapter electrodes, the plurality of third-type adapter electrodes are electrically connected to the corresponding first initialization voltage supply line, orthographic projections of the plurality of third-type adapter electrodes on the base substrate and an orthographic projection of the corresponding first initialization voltage supply line on the base substrate overlap with each other, orthographic projections of the plurality of fourth-type adapter electrodes on the base substrate and orthographic projections of the plurality of first initialization voltage supply lines on the base substrate do not overlap with each other, and at least one fourth-type adapter electrode is arranged between every two adjacent third-type adapter electrodes arranged along the first direction.

In some embodiments, the display panel includes a semiconductor layer, a first gate metal layer, a second gate metal layer, a first source-drain metal layer and a second source-drain metal layer, which are sequentially arranged in a direction away from the base substrate; the control electrode of the first transistor is in the first gate metal layer, the first electrode of the first transistor is in the semiconductor layer, the first luminescent control line and the second luminescent control line are in the first gate metal layer, the first initialization voltage line is in the second gate metal layer, the ninth adapter electrode is in the first source-drain metal layer, the first initialization voltage supply line is in the second source-drain metal layer, and the first reset signal line is in the first source-drain metal layer and is electrically connected to the control electrode of the first transistor through a seventeenth via.

In some embodiments, each pixel driving circuit further includes a data writing sub-circuit including: a fourth transistor and a second transistor; a control electrode of the fourth transistor is electrically connected to a scan line, a first electrode of the fourth transistor is electrically connected to a data line, and a second electrode of the fourth transistor is electrically connected to the first electrode of the driving transistor; and a control electrode of the second transistor is electrically connected to the scan line, a first electrode of the second transistor is electrically connected to the second electrode of the driving transistor, and a second electrode of the second transistor is electrically connected to the control electrode of the driving transistor.

In some embodiments, the display panel includes: a first gate metal layer and a first source-drain metal layer, and the first source-drain metal layer is on a side of the first gate metal layer away from the base substrate; the control electrode of the second transistor and the control electrode of the fourth transistor are in the first gate metal layer, and in any two adjacent pixel driving circuits in the first direction, the control electrode of the second transistor of one pixel driving circuit and the control electrode of the fourth transistor of the other pixel driving circuit have a one-piece structure; and the scan line is in the first source-drain metal layer and is electrically connected to the control electrode of the fourth transistor through a thirty-second via.

In some embodiments, each pixel driving circuit further includes a storage capacitor, the storage capacitor includes a first plate and a second plate opposite to each other, the first plate and the control electrode of the driving transistor have a one-piece structure, and the first power supply line is electrically connected to the second plate through a thirty-fifth via; and the display panel further includes: a sixteenth adapter electrode electrically connected to the control electrode of the driving transistor through a thirty-third via and electrically connected to the second electrode of the second transistor through a thirty-fourth via.

In some embodiments, the second plate has an avoidance notch so that an orthographic projection of the second plate on the base substrate does not overlap with an orthographic projection of the thirty-third via on the base substrate.

In some embodiments, the plurality of pixel driving circuits are arranged in a plurality of columns in a first direction and in a plurality of rows in a second direction; the display panel includes a plurality of data lines, a plurality of first initialization voltage supply lines, a plurality of second initialization voltage supply lines, a plurality of second power supply lines and a plurality of second power supply sub-lines in the same layer, second electrodes of the plurality of light-emitting devices are electrically connected to the plurality of second power supply lines, and the plurality of data lines, the plurality of first initialization voltage supply lines, the plurality of second initialization voltage supply lines, the plurality of second power supply lines and the plurality of second power supply sub-lines extend in a second direction; and the plurality of data lines include a first data line, a second data line and a third data line, pixel driving circuits in each column are electrically connected to one corresponding data line, a first side of each data line is adjacent to the corresponding second power supply sub-line, a second side of the first data line is adjacent to the corresponding first initialization voltage supply line, a second side of the second data line is adjacent to the corresponding second power supply line, and a second side of the third data line is adjacent to the corresponding second initialization voltage supply line.

In some embodiments, the display panel further includes a pixel defining layer on a side of first electrodes of the plurality of light-emitting devices away from the base substrate, the pixel defining layer has pixel openings therein, each pixel opening exposes at least a portion of the corresponding first electrode, and a luminescent functional layer of each light-emitting device is at least partially located in the corresponding pixel opening; each of some of light-emitting devices connected to each pixel driving circuit corresponds to pixel openings, and each of the remaining light-emitting devices connected to each pixel driving circuit corresponds to one pixel opening.

BRIEF DESCRIPTION OF DRAWINGS

The accompanying drawings, which are provided for further understanding of the present disclosure and constitute a part of this specification, are for explaining the present disclosure together with the embodiments of the present disclosure, but are not intended to limit the present disclosure. In the drawings:

FIG. 1 is a schematic diagram of a pixel driving circuit according to some embodiments of the present disclosure.
FIG. 2 is a schematic diagram of a pixel driving circuit applied to a display panel according to some embodiments of the present disclosure.
FIG. 3 is another schematic diagram of a pixel driving circuit applied to a display panel according to some embodiments of the present disclosure.
FIG. 4 is a schematic diagram of a specific structure of a pixel driving circuit according to some embodiments of the present disclosure.
FIG. 5 is a timing diagram of the pixel driving circuit shown in FIG. 4 in a peep-proof mode.
FIG. 6 is a timing diagram of the pixel driving circuit shown in FIG. 4 in a sharing mode.
FIG. 7 is a timing diagram of the pixel driving circuit shown in FIG. 4 in a bi-directional display mode.
FIG. 8 is a schematic diagram of another specific structure of a pixel driving circuit according to some embodiments of the present disclosure.
FIG. 9 is a timing diagram of the pixel driving circuit shown in FIG. 8 in a bi-directional display mode.
FIG. 10 is a schematic diagram of another specific structure of a pixel driving circuit according to some embodiments of the present disclosure.
FIG. 11 is a timing diagram of the pixel driving circuit in FIG. 10 in a peep-proof mode.
FIG. 12 is a timing diagram of the pixel driving circuit in FIG. 10 in a sharing mode.
FIG. 13 is a timing diagram of the pixel driving circuit in FIG. 10 in a bi-directional display mode.
FIG. 14 is a schematic plan view of a semiconductor layer of a display panel according to some embodiments of the present disclosure.
FIG. 15 is a schematic plan view of a first gate metal layer of a display panel according to some embodiments of the present disclosure.
FIG. 16 is a schematic plan view of a second gate metal layer of a display panel according to some embodiments of the present disclosure.
FIG. 17 is a schematic plan view of a first source-drain metal layer of a display panel according to some embodiments of the present disclosure.

FIG. 18 is a schematic plan view of a second source-drain metal layer of a display panel according to some embodiments of the present disclosure.

FIG. 19 is a schematic diagram of a stack of a semiconductor layer, a first gate metal layer, a second gate metal layer, a first source-drain metal layer, and a second source-drain metal layer of a display panel according to some embodiments of the present disclosure.

FIG. 20 is a schematic plan view of a transparent conductive layer of a display panel according to some embodiments of the present disclosure.

FIG. 21 is a schematic plan view of a first electrode layer of a display panel according to some embodiments of the present disclosure.

FIG. 22 is a schematic plan view of a pixel defining layer of a display panel according to some embodiments of the present disclosure.

FIG. 23 is an overall plan view of a pixel driving circuit and a first electrode layer, which are connected together, of a display panel according to some embodiments of the present disclosure.

FIG. 24 is a cross-sectional view taken along a line A-A' of FIG. 23.

FIG. 25 is a schematic plan view of a semiconductor layer of a display panel according to further embodiments of the present disclosure.

FIG. 26 is a schematic plan view of a first gate metal layer of a display panel according to further embodiments of the present disclosure.

FIG. 27 is a schematic plan view of a second gate metal layer of a display panel according to further embodiments of the present disclosure.

FIG. 28 is a schematic plan view of a first source-drain metal layer of a display panel according to further embodiments of the present disclosure.

FIG. 29 is a schematic plan view of a second source-drain metal layer of a display panel according to further embodiments of the present disclosure.

FIG. 30 is a schematic diagram of a stack of a semiconductor layer, a first gate metal layer, a second gate metal layer, a first source-drain metal layer, and a second source-drain metal layer of a display panel according to further embodiments of the present disclosure.

FIG. 31 is a schematic plan view of a transparent conductive layer of a display panel according to further embodiments of the present disclosure.

FIG. 32 is a schematic plan view of a first electrode layer of a display panel according to further embodiments of the present disclosure.

FIG. 33 is a schematic plan view of a pixel defining layer of a display panel according to further embodiments of the present disclosure.

FIG. 34 is an overall plan view of a pixel driving circuit and a first electrode layer, which are connected together, of a display panel according to further embodiments of the present disclosure.

FIG. 35 is a cross-sectional view taken along a line B-B' of FIG. 30.

FIG. 36 is a schematic plan view of a semiconductor layer of a display panel according to further embodiments of the present disclosure.

FIG. 37 is a schematic plan view of a first gate metal layer of a display panel according to further embodiments of the present disclosure.

FIG. 38 is a schematic plan view of a second gate metal layer of a display panel according to further embodiments of the present disclosure.

FIG. 39 is a schematic plan view of a first source-drain metal layer of a display panel according to further embodiments of the present disclosure.

FIG. 40 is a schematic plan view of a second source-drain metal layer of a display panel according to further embodiments of the present disclosure.

FIG. 41 is a schematic diagram of a stack of a semiconductor layer, a first gate metal layer, a second gate metal layer, a first source-drain metal layer, and a second source-drain metal layer of a display panel according to further embodiments of the present disclosure.

FIG. 42 is a schematic plan view of a transparent conductive layer of a display panel according to further embodiments of the present disclosure.

FIG. 43 is a schematic plan view of a first electrode layer of a display panel according to further embodiments of the present disclosure.

FIG. 44 is a schematic plan view of a pixel defining layer of a display panel according to further embodiments of the present disclosure.

FIG. 45 is an overall plan view of a pixel driving circuit and a first electrode layer, which are connected together, of a display panel according to further embodiments of the present disclosure.

FIG. 46 is a cross-sectional view taken along a line C-C' of FIG. 41.

DETAIL DESCRIPTION OF EMBODIMENTS

The embodiments of the present disclosure will be described in detail below with reference to the accompanying drawings. It should be understood that the embodiments of the present disclosure herein are only used to illustrate and explain the present disclosure, rather than limiting the present disclosure.

To make the objects, technical solutions and advantages of the embodiments of the present disclosure more apparent, the technical solutions of the embodiments of the present disclosure will be clearly and completely described below with reference to the drawings of the embodiments of the present disclosure. Obviously, the described embodiments are only a few, not all of, embodiments of the present disclosure. All other embodiments, which can be derived by one of ordinary skill in the art from the embodiments of the present disclosure without making any inventive effort, shall fall within the protection scope of the present disclosure.

Unless defined otherwise, technical or scientific terms used herein shall have the ordinary meaning as understood by one of ordinary skill in the art to which the present disclosure belongs. The terms "first", "second", and the like used in the present disclosure are not intended to indicate any order, quantity, or importance, but rather are used for distinguishing one element from another. Similarly, the term of "comprising", "including", or the like, means that the element or item preceding the term contains the element or item listed after the term and its equivalent, but does not exclude other elements or items. The term "connected", "coupled", or the like is not limited to physical or mechanical connections, but may include electrical connections, whether direct or indirect connections. The terms "upper", "lower", "left", "right", and the like are used only for indicating relative positional relationships, and when the absolute position of an object being described is changed, the relative positional relationships may also be changed accordingly.

It should be noted that a layer in the embodiment of the present disclosure is illustrated schematically and does not represent an actual thickness of the layer.

In addition, transistors in the embodiments of the present disclosure may be independently selected from one of a polysilicon silicon thin film transistor, an amorphous silicon thin film transistor, an oxide thin film transistor, and an organic thin film transistor. A "first electrode" in the present disclosure specifically refers to a source electrode of a transistor and a corresponding "second electrode" specifically refers to a drain electrode of the transistor. Alternatively, it should be understood by one of ordinary skill in the art that the "first electrode" and "second electrode" are interchangeable.

In addition, an operating level state refers to a level state in which the first electrode and the second electrode of the transistor may be electrically connected to each other (a signal, a current or a voltage or the like may flow between the first electrode and the second electrode of the transistor), and a non-operating level state refers to a level state in which the first electrode and the second electrode of the transistor may be electrically disconnected from each other (a signal, a current or a voltage or the like cannot flow between the first electrode and the second electrode of the transistor). The transistors may be divided into N-type transistors and P-type transistors, and the transistors in the present disclosure may be independently selected from the N-type transistors or the P-type transistors, respectively. For an N-type transistor, an operating level state is a high-level state, and a non-operating level state is a low-level state. For a P-type transistor, an operating level state is a low-level state and a non-operating level state is a high-level state. In the following embodiments, as an example, all transistors in pixel units are N-type transistors, and the transistors in the pixel driving circuit may be simultaneously manufactured by the same manufacturing process.

In the OLED display, the pixel driving circuit in each pixel provides a driving current to the light-emitting device 20 to drive the light-emitting device 20 to emit light. In the related art, the pixel driving circuits drive the corresponding light-emitting devices 20 to emit light in one display period, to display one image together.

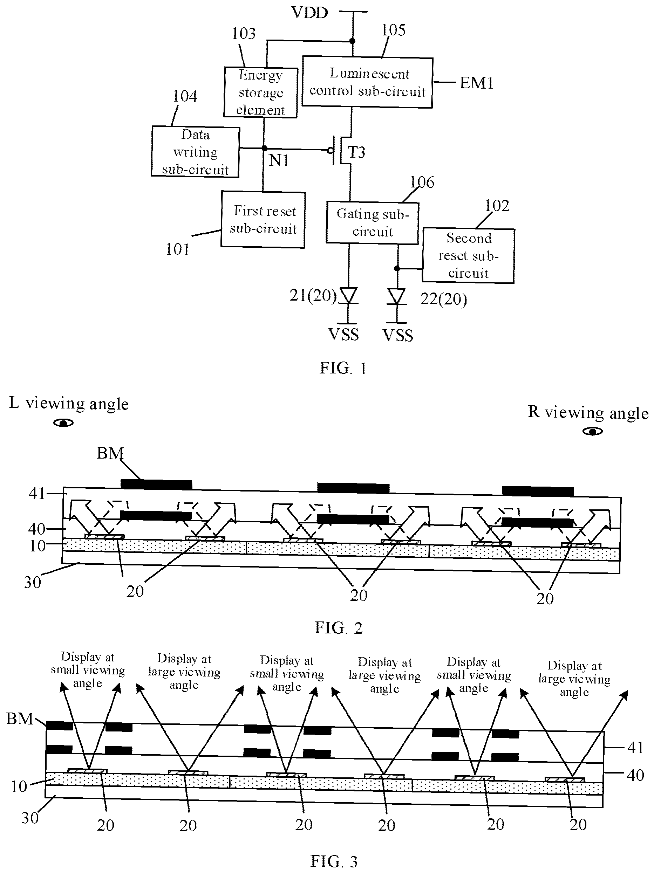

FIG. 1 is a schematic diagram of a pixel driving circuit according to some embodiments of the present disclosure. As shown in FIG. 1, the pixel driving circuit may drive a plurality of light-emitting devices 20, and includes: a driving transistor T3, a first reset sub-circuit 101, a second reset sub-circuit 102, a luminescent control sub-circuit 105, a data writing sub-circuit 104, a gating sub-circuit 106, and an energy storage element 103. The energy storage element 103 is connected between a control electrode and a first electrode of the driving transistor T3.

The first reset sub-circuit 101 is configured to write a first initialization voltage signal to the control electrode of the driving transistor T3 in response to a first reset signal.

The second reset sub-circuit 102 is configured to write a second initialization voltage signal to a first electrode 201 of at least one of the plurality of light-emitting devices 20 in response to a second reset signal. In some embodiments, each light-emitting device 20 may be a current-driven light-emitting device 20 including an LED (a light-emitting diode) or an OLED (an organic light-emitting diode). As an example, each light-emitting device 20 is the OLED in the embodiment of the present disclosure. Optionally, a first electrode 201 of each light-emitting device 20 is an anode and a second electrode of each light-emitting device 20 is a cathode. The second electrode of each light-emitting device 20 may be connected to a second power supply line VSS, which may provide a low-level signal.

The data writing sub-circuit 104 is configured to write a data voltage signal and a threshold voltage signal of the driving transistor T3 to the energy storage element 103 in response to a scan signal.

The luminescent control sub-circuit 105 is configured to electrically connect a first power supply line VDD to the first electrode of the driving transistor T3 in response to one of a first luminescent control signal and a second luminescent control signal. The first power supply line VDD may provide a high-level signal.

The gating sub-circuit 106 is configured to electrically connect a second electrode of the driving transistor T3 to different light-emitting devices 20 in response to different luminescent control signals.

The pixel driving circuit of the embodiment of the present disclosure may include a plurality of operating phases, each of which includes a reset sub-phase, a data writing sub-phase, and a luminescent sub-phase. In the reset sub-phase of each operating phase, the first reset sub-circuit 101 may be configured to write the first initialization voltage signal to the control electrode (i.e., an N1 node) of the driving transistor T3, so as to reset the N1 node. In each data writing sub-phase, the second reset sub-circuit 102 may be configured to write the second initialization voltage signal to the first electrode 201 of at least one of the plurality of light-emitting devices 20, thereby resetting the first electrode 201 of the at least one light-emitting device 20. At the same time, the data writing sub-circuit 104 may be configured to write the data voltage signal and the threshold voltage signal of the driving transistor T3 to the energy storage element 103. In each luminescent sub-phase, the luminescent control sub-circuit 105 may be configured to electrically connect the first power supply line VDD to the driving transistor T3, and in the luminescent sub-phases of the different operating phases, the gating sub-circuit 106 may be configured to electrically connect the driving transistor T3 to the different light-emitting devices 20, thereby causing the different light-emitting devices 20 to emit light in the different operating phases. Therefore, in different operating phases of each display period, the light-emitting devices 20 driven by the same pixel driving circuit may present different brightness, so that in the display panel, different light-emitting devices 20 connected by the same pixel driving circuit can emit light towards different angles in combination with black matrixes BM, and therefore, different images can be viewed at different viewing angles. For example, users in a driver's seat and a passenger seat may see different images on the same display panel.

FIG. 2 is a schematic diagram of a pixel driving circuit applied to a display panel according to some embodiments of the present disclosure. FIG. 3 is another schematic diagram of a pixel driving circuit applied to a display panel according to some embodiments of the present disclosure. In FIG. 2 and FIG. 3, as an example, each pixel driving circuit is connected to two light-emitting devices. As shown in FIG. 2, an encapsulation layer 40 is disposed on a side of the light-emitting devices 20 away from a base substrate 30, and black matrixes BM are disposed in two layers and on a side of the encapsulation layer 40 away from the base substrate 30, and orthographic projections of the corresponding black matrices BM in the two layers on the base substrate 30 may substantially coincide with each other and be located in a spacing region between two light-emitting devices 20 connected to the corresponding pixel driving circuit 10. In this case, for the two light-emitting devices 20 connected to each pixel driving circuit 10, light emitted to the L viewing angle by one of the light-emitting devices 20 is blocked by the black matrixes BM, and light emitted to the R viewing angle by the other light-emitting device 20 is blocked by the black matrixes BM, so that different images can be viewed at the L viewing angle and the R viewing angle. In FIG. 2, solid arrows indicate light that can exit the display panel, and dotted arrows indicate light that is blocked by the black matrixes BM and cannot exit the display panel.

As shown in FIG. 3, the black matrixes BM define a plurality of light-outgoing openings, and an orthographic projection of each light-outgoing opening on the base substrate 30 overlaps with an orthographic projection of one corresponding light-emitting device 20 on the base substrate 30. In this case, the display panel can realize display in a peep-proof mode and a sharing mode. Specifically, in the peep-proof mode, in the reset sub-phase, the first reset sub-circuit 101 resets the control electrode of the driving transistor T3. In the data writing sub-phase, the data writing sub-circuit 104 writes the data voltage signal and the threshold voltage signal of the driving transistor T3 to the energy storage element 103. In the luminescent sub-phase, the luminescent control sub-circuit 105 electrically connects the first power supply line VDD to the first electrode of the driving transistor T3 by appropriately configuring the luminescent control signals. The gating sub-circuit 106 electrically connects the second electrode of the driving transistor T3 to one of the light-emitting devices 20, so as to provide a driving current to the light-emitting device 20, and realize light emission at a small viewing angle, thereby realizing a peep-proof display. In the light-emitting device 20 in the sharing mode, the luminescent control sub-circuit 105 electrically connects the second electrode of the driving transistor T3 to the plurality of light-emitting devices 20 by appropriately configuring the luminescent control signals, so as to provide a driving current to the plurality of light-emitting devices 20, so that the plurality of light-emitting devices 20 emit light at the same time, thereby realizing the light emission at a large viewing angle.

In one example, as shown in FIG. 3, in two light-emitting devices 20 connected to the same pixel driving circuit 10, one of the light-emitting devices 20 corresponds to a light-outgoing opening with a smaller area, and the other light-emitting device 20 corresponds to a light-outgoing opening with a larger area. In the peep-proof mode, the light-emitting device 20 corresponding to the light-outgoing opening with the smaller area may be controlled to emit light, so as to improve the peep-proof effect.

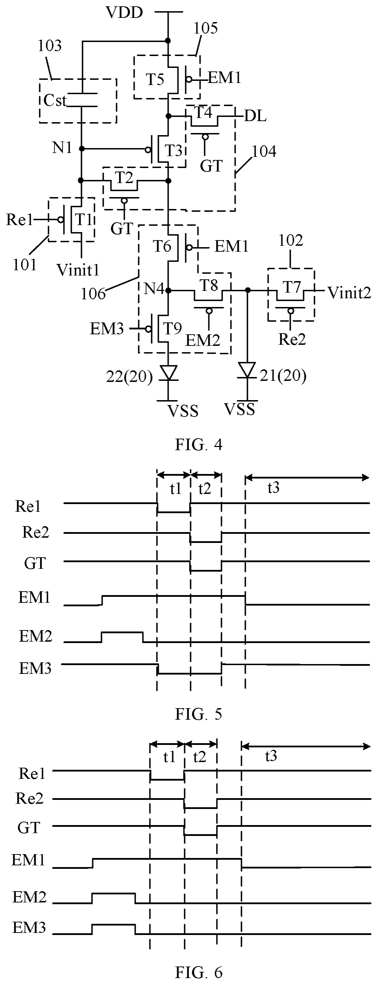

FIG. 4 is a schematic diagram of a specific structure of a pixel driving circuit according to some embodiments of the present disclosure. FIG. 4 is an implementation of FIG. 1. As shown in FIG. 4, the luminescent control sub-circuit 105 may include: a fifth transistor T5, a control electrode of the fifth transistor T5 is electrically connected to a first luminescent control line EM1, a first electrode of the fifth transistor T5 is electrically connected to the first power supply line VDD, and a second electrode of the fifth transistor T5 is electrically connected to the first electrode of the driving transistor T3. When a first luminescent control signal through the first luminescent control line EM1 is in an operating level state, the first electrode and the second electrode of the fifth transistor T5 are electrically connected to each other, thereby transmitting a signal through the first power supply line VDD to the first electrode of the driving transistor T3.

In some embodiments, the gating sub-circuit 106 includes: a sixth transistor T6, an eighth transistor T8, and a ninth transistor T9. A control electrode of the sixth transistor T6 is electrically connected to the first luminescent control line EM1, and a first electrode of the sixth transistor T6 is electrically connected to the second electrode of the driving transistor T3. A control electrode of the eighth transistor T8 is electrically connected to a second luminescent control line EM2, a first electrode of the eighth transistor T8 is electrically connected to a second electrode of the sixth transistor T6, and a second electrode of the eighth transistor T8 is electrically connected to a first light-emitting device 21. A control electrode of the ninth transistor T9 is electrically connected to a third luminescent control line EM3, a first electrode of the ninth transistor T9 is electrically connected to the second electrode of the sixth transistor T6, and a second electrode of the ninth transistor T9 is electrically connected to a second light-emitting device 22.

When both the first luminescent control signal through the first luminescent control line EM1 and the second luminescent control signal through the second luminescent control line EM2 are in an operating level state, the sixth transistor T6 electrically connects the second electrode of the driving transistor T3 and an N4 node, and the eighth transistor T8 electrically connects the N4 node to the first light-emitting device 21, thereby providing a driving current to the first light-emitting device 21. When both the first luminescent control signal through the first luminescent control line EM1 and the third luminescent control signal through the third luminescent control line EM3 are in an operating level state, the sixth transistor T6 electrically connects the second electrode of the driving transistor T3 to the N4 node, and the ninth transistor T9 electrically connects the N4 node to the second light-emitting device 22, thereby providing a driving current to the second light-emitting device 22.

In some embodiments, as shown in FIG. 4, the first reset sub-circuit 101 includes: a first transistor T1, a control electrode of the first transistor T1 is electrically connected to a first reset signal line Re1, a first electrode of the first transistor T1 is electrically connected to a first initialization voltage line Vinit1, and a second electrode of the first transistor T1 is electrically connected to the control electrode of the driving transistor T3. When a first reset signal through the first reset signal line Re1 is in an operating level state, a voltage through the first initialization voltage line Vinit1 is written to the N1 node through the first reset signal, thereby resetting the N1 node.

In some embodiments, as shown in FIG. 4, the second reset sub-circuit 102 includes: a seventh transistor T7, a control electrode of the seventh transistor T7 is electrically connected to a second reset signal line Re2, a first electrode of the seventh transistor T7 is electrically connected to a second initialization voltage line Vinit2, and a second electrode of the seventh transistor T7 is electrically connected to the first electrode 201 of the first light-emitting device 21. When a second reset signal through the second reset signal line Re2 is in an operating level state, the seventh transistor T7 writes a voltage on the second initialization voltage line Vinit2 to the first electrode 201 of the first light-emitting device 21, thereby resetting the first electrode 201 of the first light-emitting device 21.

In some embodiments, the plurality of pixel driving circuits are arranged in an array, and in every two adjacent rows of pixel driving circuits, the second reset signal line Re2 connected to the pixel driving circuits in the previous row and the first reset signal line Re1 connected to the pixel driving circuits in the next row may be shared with each other.

In some embodiments, the data writing sub-circuit 104 includes: a fourth transistor T4 and a second transistor T2. A control electrode of the fourth transistor T4 is electrically connected to a scan line GT, a first electrode of the fourth transistor T4 is electrically connected to a data line DL, and a second electrode of the fourth transistor T4 is electrically connected to the first electrode of the driving transistor T3. A control electrode of the second transistor T2 is electrically connected to the scan line GT, a first electrode of the second transistor T2 is electrically connected to the second electrode of the driving transistor T3, and the second electrode of the second transistor T2 is electrically connected to the control electrode of the driving transistor T3.

In some embodiments, the energy storage element 103 includes a storage capacitor Cst including a first plate electrically connected to the control electrode of the driving transistor T3 and a second plate electrically connected to the first electrode of the driving transistor T3.

FIG. 5 is a timing diagram of the pixel driving circuit shown in FIG. 4 in a peep-proof mode. As shown in FIG. 5, the pixel driving circuit includes a reset sub-phase t1, a data writing sub-phase t2 and a luminescent sub-phase t3 in each display period.

In the reset sub-phase t1, the first reset signal is in an operating level state, and therefore, the first transistor T1 is turned on, so that a voltage signal through the first initialization voltage line Vinit1 is transmitted to the N1 node, thereby resetting the N1 node. In addition, a scan signal through the scan line GT, a second reset signal through the second reset signal line Re2, and a first luminescent control signal through the first luminescent control line EM1 are all in a non-operating level state, so that the second transistor T2, the fourth transistor T4, the fifth transistor T5, the sixth transistor T6, and the seventh transistor T7 are all turned off. A second luminescent control signal through the second luminescent control line EM2 and a third luminescent control signal through the third luminescent control line EM3 may be in an operating level state, so that the eighth transistor T8 and the ninth transistor T9 are both turned on.

In the data writing sub-phase t2, a second reset signal through the second reset signal line Re2, a second luminescent control signal through the second luminescent control line EM2, and a third luminescent control signal through the third luminescent control line EM3 are all in an operating level state, so that the seventh transistor T7, the eighth transistor T8, and the ninth transistor T9 are turned on, and thus a voltage signal through the second initialization voltage line Vinit2 may be transmitted to the first electrode 201 of the first light-emitting device 21 and the first electrode 201 of the second light-emitting device 22, thereby resetting these two first electrodes 201. In addition, a scan signal through the scan line GT is in an operating level state, so that the second transistor T2 and the fourth transistor T4 are turned on, a data voltage signal through the data line DL is written into the first electrode of the driving transistor T3, and the control electrode and the second electrode of the driving transistor T3 are short-circuited with each other, thereby forming a diode structure. At this time, the data voltage signal flows to the control electrode of the driving transistor T3 through the driving transistor T3 and the second transistor T2, so that a potential of the control electrode of the driving transistor T3 reaches Vdata + Vth, where Vth is a threshold voltage of the second transistor T2 and Vdata is a voltage of the data voltage signal.

In the luminescent sub-phase t3, a first luminescent control signal through the first luminescent control line EM1 and a second luminescent control signal through the second luminescent control line EM2 are both in an operating level state, and a first reset signal through the first reset signal line Re1, a second reset signal through the second reset signal line Re2, a scan signal through the scan line GT, and a third luminescent control signal through the third luminescent control line EM3 are all in a non-operating level state. At this time, the fifth transistor T5, the sixth transistor T6, the eighth transistor T8, and the driving transistor T3 are all turned on, and the first transistor T1, the second transistor T2, the fourth transistor T4, the seventh transistor T7, and the ninth transistor T9 are all turned off. The potential of the control electrode of the driving transistor T3 is maintained at Vdata + Vth under a voltage holding of the storage capacitor Cst, a voltage through the first power supply line VDD generates a driving current through the fifth transistor T5 and the driving transistor T3, and the driving current flows into the first light-emitting device 21, and the second light-emitting device 22 does not emit light. At this time, the driving current $I_{OLED}$ satisfies the following saturation current formula:

$$I_{OLED}=K(Vgs-Vth)^2=K(Vdata+Vth-ELVDD-Vth)^2=K(Vdata-ELVDD)^2 \qquad (1)$$

Where K is a coefficient related to the characteristics of the driving transistor T3 itself, Vgs is a gate-source voltage of the driving transistor T3, i.e., a voltage between the control electrode and the first electrode of the driving transistor T3, and ELVDD is a voltage from the first power supply line VDD.

FIG. 6 is a timing diagram of the pixel driving circuit shown in FIG. 4 in a sharing mode. As shown in FIG. 6, the pixel driving circuit includes a reset sub-phase t1, a data writing sub-phase t2 and a luminescent sub-phase t3 in each display period.

In the reset sub-phase t1 and the data writing sub-phase t2 in the sharing mode, a timing of each signal is the same as that in the peep-proof mode, and a switching state of each transistor may be described above, and is not described again here.

In the luminescent sub-phase t3 in the sharing mode, a first reset signal through the first reset signal line Re1, a second reset signal through the second reset signal line Re2, and a scan signal through the scan line GT are all in a non-operating level state, so that the first transistor T1, the seventh transistor T7, the second transistor T2, and the fourth transistor T4 are all turned off. A first luminescent control signal through the first luminescent control line EM1, a second luminescent control signal through the second luminescent control line EM2, and a third luminescent control signal through the third luminescent control line EM3 are all in an operating level state, so that the fifth transistor T5, the sixth transistor T6, the eighth transistor T8, and the ninth transistor T9 are all turned on, the voltage through the first power supply line VDD generates a driving current through the fifth transistor T5 and the driving transistor T3 and the driving current flows into the first light-emitting device 21 and the second light-emitting device 22, and therefore, the first light-emitting device 21 and the second light-emitting device 22 both emit light, and the viewing angle is increased. The driving current is described in the above formula.

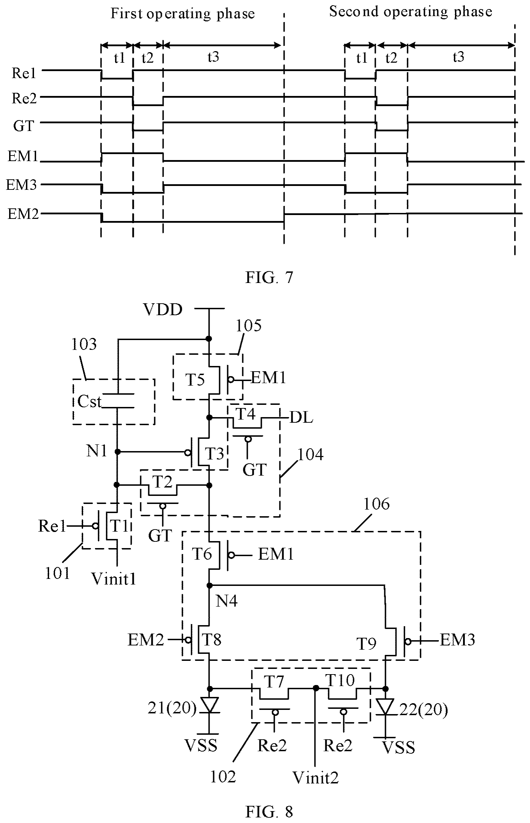

FIG. 7 is a timing diagram of the pixel driving circuit shown in FIG. 4 in a bi-directional display mode. As shown in FIG. 7, the pixel driving circuit includes two operating phases in each display period, and each operating phase includes a reset sub-phase t1, a data writing sub-phase t2 and a luminescent sub-phase t3.

In the reset sub-phase t1 of a first operating phase, a first reset signal is in an operating level state, and therefore, the first transistor T1 is turned on, so that a voltage signal through the first initialization voltage line Vinit1 is transmitted to the N1 node, and the N1 node is reset. In addition, a scan signal through the scan line GT, a second reset signal through the second reset signal line Re2, and a first luminescent control signal through the first luminescent control line EM1 are all in a non-operating level state, so that the second transistor T2, the fourth transistor T4, the fifth transistor T5, the sixth transistor T6, and the seventh transistor T7 are all turned off. A second luminescent control signal through the second luminescent control line EM2 and a third luminescent control signal through the third luminescent control line EM3 may be in an operating level state, so that the eighth transistor T8 and the ninth transistor T9 are all turned on.

In the data writing sub-phase t2 of the first operating phase, a second reset signal through the second reset signal line Re2, a second luminescent control signal through the second luminescent control line EM2, and a third luminescent control signal through the third luminescent control line EM3 are all in an operating level state, so that the seventh transistor T7, the eighth transistor T8, and the ninth transistor T9 are turned on, and a voltage signal through the second initialization voltage line Vinit2 may be transmitted to the first electrode 201 of the first light-emitting device 21 and the first electrode 201 of the second light-emitting device 22, thereby resetting these two first electrodes 201. In addition, a scan signal through the scan line GT is in an operating level state, so that the second transistor T2 and the fourth transistor T4 are turned on, a data voltage signal through the data line DL is written into the first electrode of the driving transistor T3, and the control electrode and the second electrode of the driving transistor T3 are short-circuited with each other to form a diode structure. At this time, the data voltage signal flows to the control electrode of the driving transistor T3 through the driving transistor T3 and the second transistor T2, and a potential of the control electrode of the driving transistor T3 reaches Vdata + Vth.

In the luminescent sub-phase t3 of the first operating phase, a first luminescent control signal through the first luminescent control line EM1 and a second luminescent control signal through the second luminescent control line EM2 are both in an operating level state, and a third luminescent control signal through the third luminescent control line EM3, a scan signal through the scan line GT, a first reset signal through the first reset signal line Re1, and a second reset signal through the second reset signal line Re2 are all in a non-operating level state. At this time, the fifth transistor T5, the sixth transistor T6, the eighth transistor T8, and the driving transistor T3 are all turned on, and the first transistor T1, the second transistor T2, the fourth transistor T4, the seventh transistor T7, the ninth transistor T9, and the tenth transistor T10 are all turned off. The potential of the control electrode of the driving transistor T3 is maintained at Vdata + Vth under a voltage holding of the storage capacitor Cst, a voltage through the first power supply line VDD generates a driving current through the fifth transistor T5 and the driving transistor T3 and the driving current flows into the first light-emitting device 21. A magnitude of the driving current is described in the above formula (1).

In the reset sub-phase t1 of a second operating phase, a first reset signal is in an operating level state, and therefore, the first transistor T1 is turned on, so that a voltage signal through the first initialization voltage line Vinit1 is transmitted to the N1 node, and the N1 node is reset. In addition, a scan signal through the scan line GT, a second reset signal through the second reset signal line Re2, a first luminescent control signal through the first luminescent control line EM1, and a third luminescent control signal through the third luminescent control line EM3 are all in a non-operating level state, so that the second transistor T2, the fourth transistor T4, the fifth transistor T5, the sixth transistor T6, the seventh transistor T7, and the ninth transistor T9 are all turned off. A second luminescent control signal through the second luminescent control line EM2 may be in an operating level state, so that the eighth transistor T8 is turned on.

In the data writing sub-phase t2 of the second operating phase, a second reset signal through the second reset signal line Re2 and a third luminescent control signal through the third luminescent control line EM3 are both in an operating level state, so that the seventh transistor T7 and the ninth transistor T9 are turned on, and a voltage signal through the second initialization voltage line Vinit2 may be transmitted to the first electrode 201 of the second light-emitting device 22. In addition, a scan signal through the scan line GT is in an operating level state, so that the second transistor T2 and the fourth transistor T4 are turned on. A potential of the control electrode of the driving transistor T3 reaches Vdata + Vth, as in the data writing sub-phase of the first operating phase.

In the luminescent sub-phase t3 of the second operating phase, a first luminescent control signal through the first luminescent control line EM1 and a third luminescent control signal through the third luminescent control line EM3 are both in an operating level state, and a second luminescent control signal through the second luminescent control line EM2, a scan signal through the scan line GT, a first reset signal through the first reset signal line Re1, and a second reset signal through the second reset signal line Re2 are all in a non-operating level state. At this time, the fifth transistor T5, the sixth transistor T6, the ninth transistor T9, and the driving transistor T3 are all turned on, and the first transistor T1, the second transistor T2, the fourth transistor T4, the seventh transistor T7, and the eighth transistor T8 are all turned off. A potential of the control electrode of the driving transistor T3 is maintained at Vdata + Vth under a voltage holding of the storage capacitor Cst, a voltage through the first power supply line VDD generates a driving current through the fifth transistor T5 and the driving transistor T3 and the driving current flows into the second light-emitting device 22. A magnitude of the driving current is described in the above formula (1).

It can be seen that in each display period, the pixel driving circuit may drive the two light-emitting devices 20 to emit light respectively in a time-sharing manner, so that the bi-directional display can be realized.

FIG. 8 is a schematic diagram of another specific structure of a pixel driving circuit according to some embodiments of the present disclosure. FIG. 8 is another implementation of FIG. 1. As in FIG. 4, in FIG. 8, the first reset sub-circuit 101 includes the first transistor T1; the data writing sub-circuit 104 includes the second transistor T2 and the fourth transistor T4; the luminescent control sub-circuit 105 specifically includes the fifth transistor T5; and the gating sub-circuit 106 includes the sixth transistor T6, the eighth transistor T8, and the ninth transistor T9. The connection for the first transistor T1, the second transistor T2, the fourth transistor T4, the fifth transistor T5, the sixth transistor T6, the eighth transistor T8, the ninth transistor T9 and the driving transistor T3 is the same as that in FIG. 4, and is not described again here.

Unlike the pixel driving circuit shown in FIG. 4, in FIG. 8, the second reset sub-circuit 102 includes: the seventh transistor T7 and a tenth transistor T10. The control electrode of the seventh transistor T7 is connected to the second reset signal line Re2, the first electrode of the seventh transistor T7 is electrically connected to the second initialization voltage line Vinit2, and the second electrode of the seventh transistor T7 is electrically connected to the first electrode 201 of the first light-emitting device 21. A control electrode of the tenth transistor T10 is electrically connected to the second reset signal line Re2, a first electrode of the tenth transistor T10 is electrically connected to the second initialization voltage line Vinit2, and a second electrode of the tenth transistor T10 is electrically connected to the first electrode 201 of the second light-emitting device 22.

In the peep-proof mode, the timing of each signal of the pixel driving circuit shown in FIG. 8 is the same as that in FIG. 5. In the reset sub-phase t1, the first transistor T1 is turned on, so that a voltage signal through the first initialization voltage line Vinit1 is transmitted to the N1 node, thereby resetting the N1 node. The second transistor T2, the fourth transistor T4, the fifth transistor T5, the sixth transistor T6, the seventh transistor T7 and the tenth transistor T10 are all turned off. In the data writing sub-phase t2, the seventh transistor T7, the tenth transistor T10, the eighth transistor T8, and the ninth transistor T9 are turned on, and thus a voltage signal through the second initialization voltage line Vinit2 is transmitted to the first electrode 201 of the first light-emitting device 21 through the seventh transistor T7, and is transmitted to the first electrode 201 of the second light-emitting device 22 through the tenth transistor T10. In addition, the second transistor T2 and the fourth transistor T4 are turned on, a potential of the control electrode of the driving transistor T3 reaches Vdata + Vth. In the luminescent sub-phase t3, the fifth transistor T5, the sixth transistor T6, the eighth transistor T8, and the driving transistor T3 are all turned on, and the first transistor T1, the second transistor T2, the fourth transistor T4, the seventh transistor T7, the ninth transistor T9 and the tenth transistor T10 are all turned off. The driving transistor T3 provides a driving current to the first light-emitting device 21 and the second light-emitting device 22 does not emit light.

In the sharing mode, the timing of each signal of the pixel driving circuit shown in FIG. 8 is the same as that in FIG. 6. In the sharing mode, switching states of the first transistor T1 to the ninth transistor T9 in the sub-phases are the same as those in the pixel driving circuit in FIG. 4 in the sub-phases in the sharing mode, and are not described again here. A switching state of the tenth transistor T10 is the same as that of the seventh transistor T7 in the sub-phases.

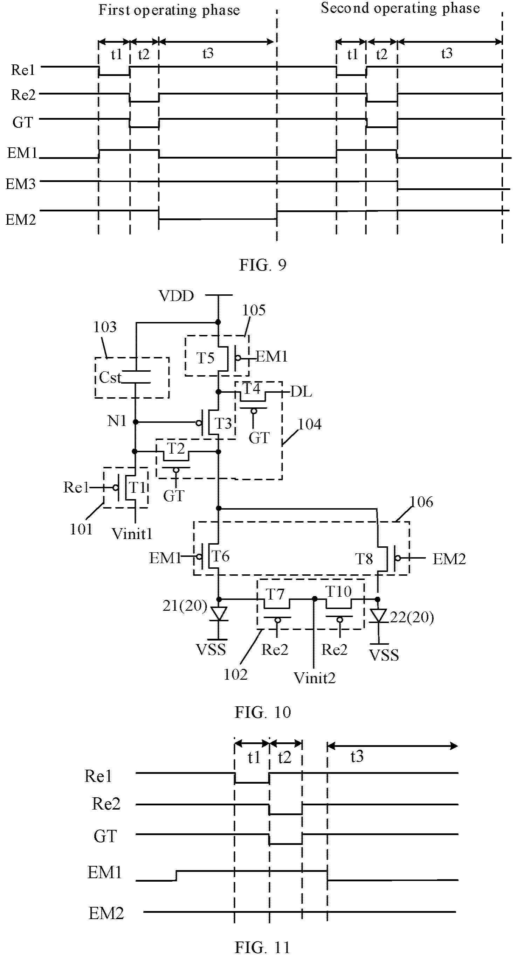

FIG. 9 is a timing diagram of the pixel driving circuit shown in FIG. 8 in a bi-directional display mode. As shown in FIG. 9, the pixel driving circuit includes two operating phases in each display period, and each operating phase includes a reset sub-phase t1, a data writing sub-phase t2 and a luminescent sub-phase t3.

In the reset sub-phase t1 of a first operating phase, a first reset signal is in an operating level state, and a second reset signal, a scan signal, a first luminescent control signal, a second luminescent control signal and a third luminescent control signal are all in a non-operating level state. The first transistor T1 is turned on, so that a voltage signal through the first initialization voltage line Vinit1 is transmitted to the control electrode of the driving transistor T3, and the control electrode of the driving transistor T3 is reset. The remaining transistors are all turned off.

In the data writing sub-phase t2 of the first operating phase, a scan signal and a second reset signal are all in an operating level state, and a first reset signal, a first luminescent control signal, a second luminescent control signal and a third luminescent control signal are all in a non-operating level state. At this time, the seventh transistor T7 and the tenth transistor T10 are turned on, so that a second initialization voltage signal through the second initialization voltage line Vinit2 is written to the first electrode 201 of each light-emitting device 20. And the second transistor T2 and the fourth transistor T4 are turned on, so that the data voltage signal flows to the control electrode of the driving transistor T3 through the driving transistor T3 and the second transistor T2, and a potential of the control electrode of the driving transistor T3 reaches Vdata + Vth.

In the luminescent sub-phase t3 of the first operating phase, a first reset signal, a second reset signal, a scan signal and a third luminescent control signal are all in a non-operating level state, and a first luminescent control signal and a second luminescent control signal are both in an operating level state. At this time, the first transistor T1, the second transistor T2, the fourth transistor T4, the seventh transistor T7, the ninth transistor T9, and the tenth transistor T10 are all turned off, and the fifth transistor T5, the sixth transistor T6, the driving transistor T3 and the eighth transistor T8 are all turned on. The potential of the control electrode of the driving transistor T3 is maintained at Vdata + Vth. The driving transistor T3 provides a driving current to the first light-emitting device 21. A magnitude of the driving current is described in the above formula (1).

In the reset sub-phase t1 and the data writing sub-phase t2 of a second operating phase, the timing of each signal is the same as that in the reset sub-phase t1 and the data writing sub-phase t2 of the first operating phase, and for the switching states of each transistor, reference may be made to those in the reset sub-phase t1 and the data writing sub-phase t2 of the first operating phase.

In the luminescent sub-phase t3 of the second operating phase, a first reset signal, a second reset signal, a scan signal and a second luminescent control signal are all in a non-operating level state, and a first luminescent control signal and a third luminescent control signal are both in an operating level state. At this time, the fifth transistor T5, the sixth transistor T6, the ninth transistor T9, and the driving transistor T3 are all turned on, and the first transistor T1, the second transistor T2, the fourth transistor T4, the seventh transistor T7, the eighth transistor T8, and the tenth transistor T10 are all turned off. A potential of the control electrode of the driving transistor T3 is maintained at Vdata + Vth. The driving transistor T3 provides a driving current to the second light-emitting device 22. A magnitude of the driving current is described in the above formula (1).

FIG. 10 is a schematic diagram of another specific structure of a pixel driving circuit according to some embodiments of the present disclosure. FIG. 10 is another implementation of FIG. 1. As in FIG. 8, in FIG. 10, the first reset sub-circuit 101 includes the first transistor T1; the data writing sub-circuit 104 includes the second transistor T2 and the fourth transistor T4; and the energy storage element 103 includes the storage capacitor Cst. For the connection for the first transistor T1, the second transistor T2, the fourth transistor T4, and the storage capacitor Cst, reference may be made to the description for FIG. 8. The second reset sub-circuit includes the seventh transistor T7 and the tenth transistor T10. The control electrode of the seventh transistor T7 and the control electrode of the tenth transistor T10 are electrically connected to the second reset signal line Re2, the first electrode of the seventh transistor T7 is electrically connected to the second initialization voltage line Vinit2, and the second electrode of the seventh transistor T7 is electrically connected to the first electrode 201 of the first light-emitting device 21. The first electrode of the tenth transistor T10 is electrically connected to the second initialization voltage line Vinit2, and the second electrode of the tenth transistor T10 is electrically connected to the first electrode 201 of the second light-emitting device 22.

Unlike those in FIG. 8, in FIG. 10, the luminescent control sub-circuit 105 includes: the fifth transistor T5 and a ninth transistor T9. The gating sub-circuit 106 includes the sixth transistor T6 and the eighth transistor T8. The control electrode of the fifth transistor T5 is electrically connected to the first luminescent control line EM1, the first electrode of the fifth transistor T5 is electrically connected to the first power supply line VDD, and the second electrode of the fifth transistor T5 is electrically connected to the first electrode of the driving transistor T3. The control electrode of the ninth transistor T9 is electrically connected to the second luminescent control line EM2, the first electrode of the ninth transistor T9 is electrically connected to the first power supply line VDD, and the second electrode of the ninth transistor T9 is electrically connected to the first electrode of the driving transistor T3. The control electrode of the sixth transistor T6 is electrically connected to the first luminescent control line EM1, the first electrode of the sixth transistor T6 is electrically connected to the second electrode of the driving transistor T3, and the second electrode of the sixth transistor T6 is electrically connected to the first light-emitting device 21. The control electrode of the eighth transistor T8 is electrically connected to the second luminescent control line EM2, the first electrode of the eighth transistor T8 is electrically connected to the second electrode of the driving transistor T3, and the second electrode of the eighth transistor T8 is electrically connected to the second light-emitting device 22.

FIG. 11 is a timing diagram of the pixel driving circuit in FIG. 10 in a peep-proof mode. As shown in FIG. 11, the pixel driving circuit includes a reset sub-phase t1, a data writing sub-phase t2 and a luminescent sub-phase t3 in each display period.

In the reset sub-phase t1, a first reset signal through the first reset signal line Re1 is in an operating level state, so that the first transistor T1 is turned on, a voltage signal through the first initialization voltage line Vinit1 is transmitted to the N1 node, and the N1 node is reset. In addition, a second reset signal through the second reset signal line Re2, a scan signal through the scan line GT, a first luminescent control signal through the first luminescent control line EM1, and a second luminescent control signal through the second luminescent control line EM2 are all in a non-operating level state, so that the second transistor T2 to the tenth transistor T10 are all turned off.

In the data writing sub-phase t2, a second reset signal is in an operating level state, so that the seventh transistor T7 and the tenth transistor T10 are turned on, and a voltage signal through the second initialization voltage line Vinit2 is transmitted to the first electrode 201 of the first light-emitting device 21 and the first electrode 201 of the second light-emitting device 22. In addition, a scan signal is in an operating level state, so that the second transistor T2 and the fourth transistor T4 are turned on, a data voltage signal flows to the control electrode of the driving transistor T3 through the driving transistor T3 and the second transistor T2, and a potential of the control electrode of the driving transistor T3 reaches Vdata + Vth. In addition, in the data writing sub-phase t2, a first reset signal, a first luminescent control signal, and a second luminescent control signal are all in a non-operating level state, so that the first transistor T1, the fifth transistor T5, the sixth transistor T6, the eighth transistor T8, and the ninth transistor T9 are all turned off.

In the luminescent sub-phase t3, a first luminescent control signal is in an operating level state, so that the fifth transistor T5 and the sixth transistor T6 are turned on, a voltage through the first power supply line VDD generates a driving current through the fifth transistor T5 and the driving transistor T3, and the driving current flows into the first light-emitting device 21. In addition, a second luminescent control signal, a first reset signal, a second reset signal, and a scan signal are all in a non-operating level state, so that the ninth transistor T9, the eighth transistor T8, the first transistor T1, the second transistor T2, and the fourth transistor T4 are all turned off, and the second light-emitting device 22 does not emit light.

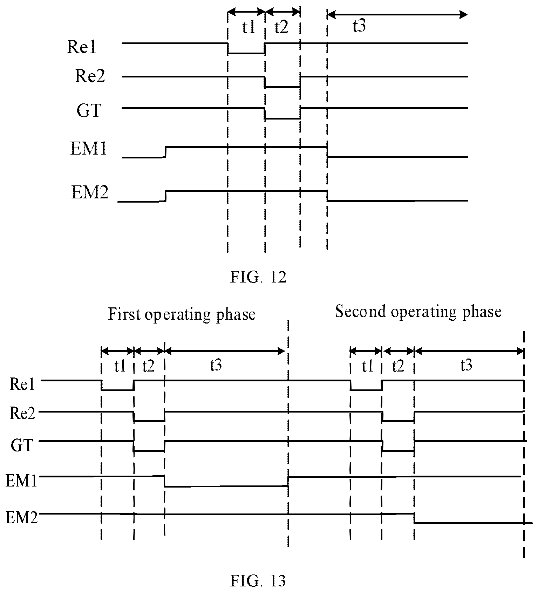

FIG. 12 is a timing diagram of the pixel driving circuit in FIG. 10 in a sharing mode. As shown in FIG. 12, the pixel driving circuit includes a reset sub-phase t1, a data writing sub-phase t2 and a luminescent sub-phase t3 in each display period.

In the reset sub-phase t1 and the data writing sub-phase t2 in the sharing mode, a timing of each signal is the same as that in the peep-proof mode, and for a switching state of each transistor, reference may be made to those in the reset sub-phase t1 and the data writing sub-phase t2 in the peep-proof mode, which is not described again here.

In the luminescent sub-phase in the sharing mode, a first luminescent control signal and a second luminescent control signal are both in an operating level state, so that the fifth transistor T5, the sixth transistor T6, the eighth transistor T8, the ninth transistor T9 and the driving transistor T3 are all turned on, and therefore, the driving current is transmitted to the first light-emitting device 21 and the second light-emitting device 22, and the first light-emitting device 21 and the second light-emitting device 22 emit light at the same time. In addition, a first reset signal, a second reset signal, and a scan signal are all in a non-operating level state, so that the first transistor T1, the second transistor T2, the fourth transistor T4, the seventh transistor T7, and the tenth transistor T10 are all turned off.

FIG. 13 is a timing diagram of the pixel driving circuit in FIG. 10 in a bi-directional display mode. As shown in FIG. 13, the pixel driving circuit includes two operating phases in each display period, and each operating phase includes a reset sub-phase t1, a data writing sub-phase t2 and a luminescent sub-phase t3.

In the reset sub-phase t1 of a first operating phase, a first reset signal is in an operating level state, so that the first transistor T1 is turned on, a voltage signal through the first initialization voltage line Vinit1 is transmitted to the N1 node, and the N1 node is reset. In addition, a second reset signal, a scan signal, a first luminescent control signal, and a second luminescent control signal are all in a non-operating level state, so that the second transistor T2, and the fourth transistor T4 to the tenth transistor T10 are all turned off.

In the data writing sub-phase t2 of the first operating phase, a second reset signal is in an operating level state, so that the seventh transistor T7 and the tenth transistor T10 are turned on, and a voltage signal through the second initialization voltage line Vinit2 is transmitted to the first electrode 201 of the first light-emitting device 21 and the first electrode 201 of the second light-emitting device 22. In addition, a scan signal is in an operating level state, so that the second transistor T2 and the fourth transistor T4 are turned on, a data voltage signal flows to the control electrode of the driving transistor T3 through the driving transistor T3 and the second transistor T2, and a potential of the control electrode of the driving transistor T3 reaches Vdata + Vth. In addition, in the data writing sub-phase t2, a first reset signal, a first luminescent control signal, and a second luminescent control signal are all in a non-operating level state, so that the first transistor T1, the fifth transistor T5, the sixth transistor T6, the eighth transistor T8, and the ninth transistor T9 are all turned off.

In the luminescent sub-phase t3 of the first operating phase, a first luminescent control signal is in an operating level state, so that the fifth transistor T5 and the sixth transistor T6 are turned on, a voltage through the first power supply line VDD generates a driving current through the fifth transistor T5 and the driving transistor T3, and the driving current flows into the first light-emitting device 21. In addition, a second luminescent control signal, a first reset signal, a second reset signal, and a scan signal are all in a non-operating level state, so that the ninth transistor T9, the eighth transistor T8, the first transistor T1, the second transistor T2, and the fourth transistor T4 are all turned off, and the second light-emitting device 22 does not emit light.

In the reset sub-phase t1 and the data writing sub-phase t2 of a second operating phase, the timing of each signal is the same as that in the reset sub-phase t1 and the data writing sub-phase t2 of the first operating phase, and the switching states of each transistor are the same as those in the reset sub-phase t1 and the data writing sub-phase t2 of the first operating phase, and are not described again here.

In the luminescent sub-phase T3 of the second operating phase, a second luminescent control signal is in an operating level state, so that the ninth transistor T9 and the eighth transistor T8 are turned on, and a voltage through the first power supply line VDD generates a driving current through the fifth transistor T5 and the driving transistor T3, and the driving current flows into the second light-emitting device 22. In addition, a first luminescent control signal, a first reset signal, a second reset signal, and a scan signal are all in a non-operating level state, so that the fifth transistor T5, the sixth transistor T6, the first transistor T1, the seventh transistor T7, the eighth transistor T8, the fourth transistor T4, and the second transistor T2 are all turned off, and the first light-emitting device 21 does not emit light.

The present disclosure further provides a display panel, including a plurality of pixel driving circuits, each of which is electrically connected to a plurality of light-emitting devices 20. Each pixel driving circuit includes: a driving transistor T3, a luminescent control sub-circuit 105, and a gating sub-circuit 106. The luminescent control sub-circuit 105 is configured to electrically connect a first power supply line VDD to a first electrode of the driving transistor T3 in response to a first luminescent control signal through a first luminescent control line EM1 or a second luminescent control signal through a second luminescent control line EM2. The gating sub-circuit 106 is configured to electrically connect a second electrode of the driving transistor T3 to different light-emitting devices 20 in response to different luminescent control signals.

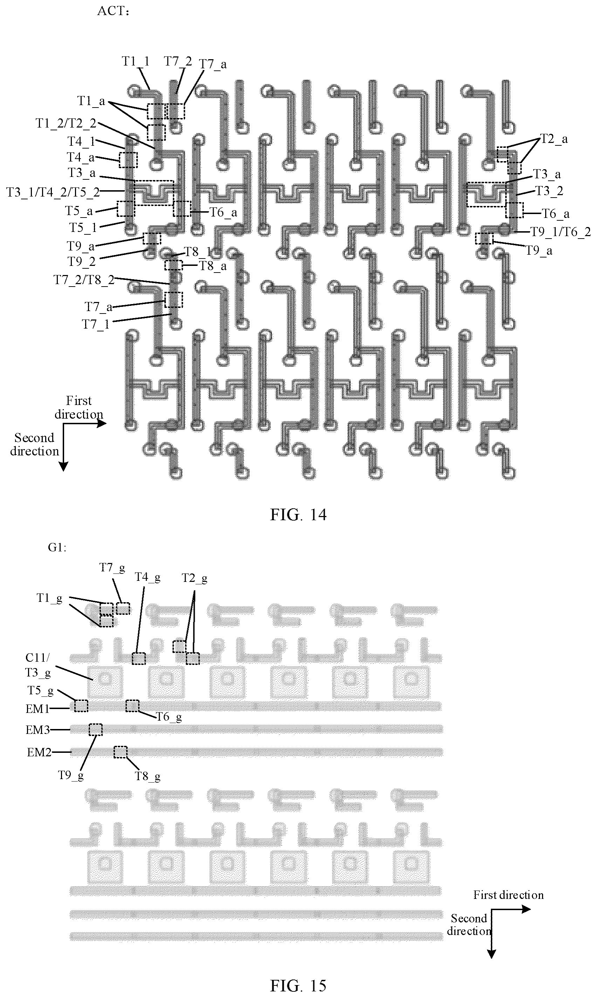

In some embodiments, the pixel driving circuit employs the structure in FIG. 4. In this case, layouts of the layers in the display panel are shown in FIG. 14 to FIG. 23. In the embodiment of the present disclosure, as an example, the pixel driving circuits are arranged in an array, and are arranged in a plurality of rows along the second direction and in a plurality of columns along a first direction.

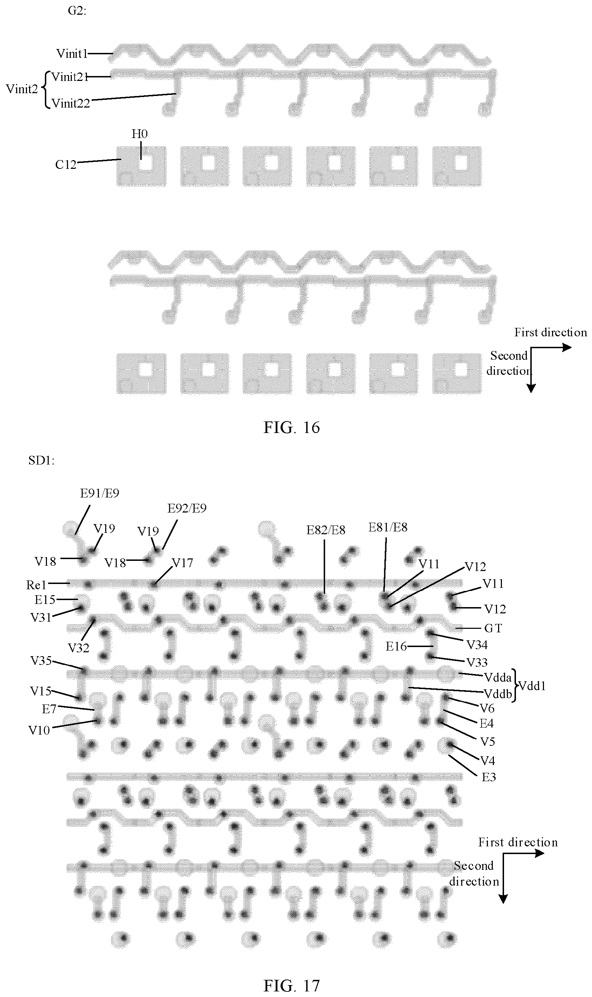

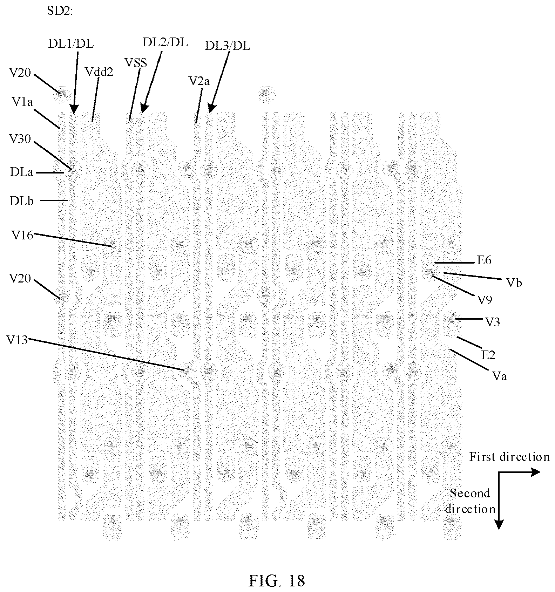

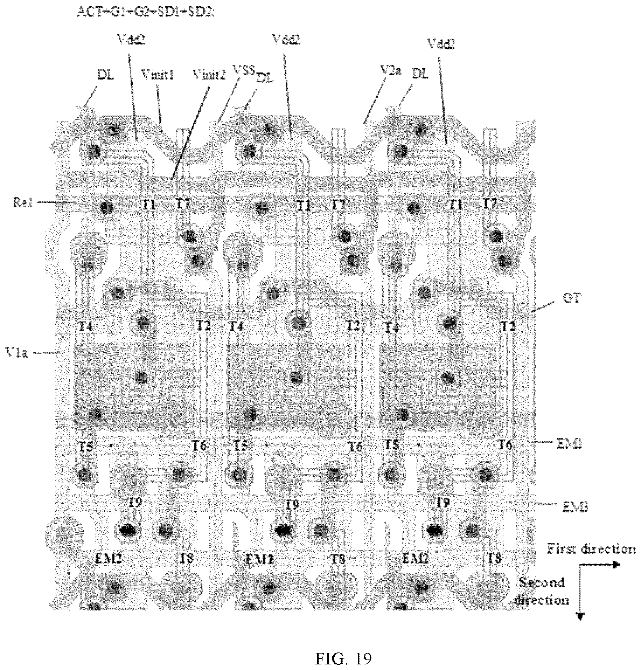

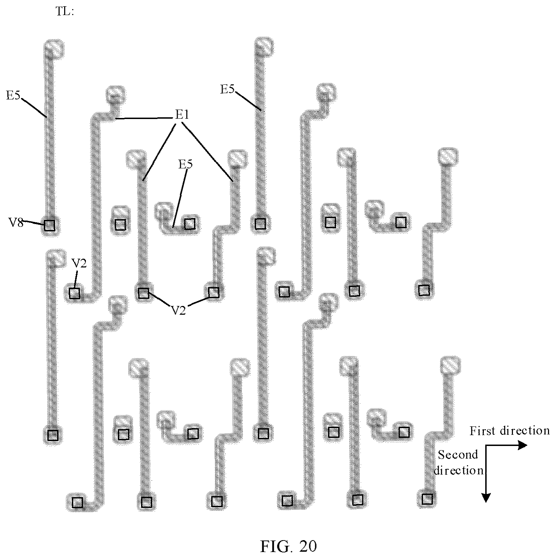

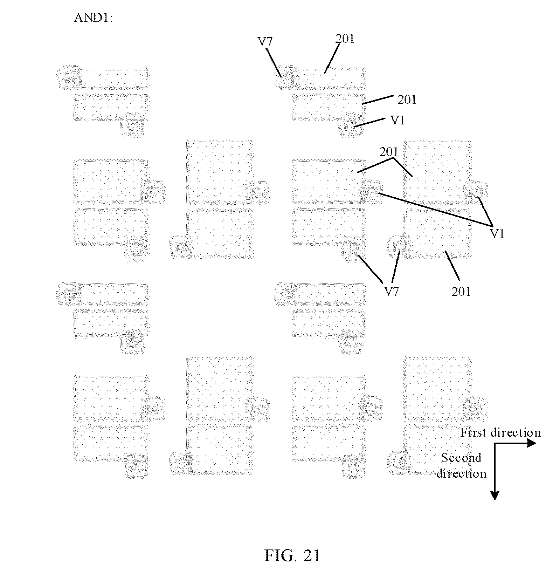

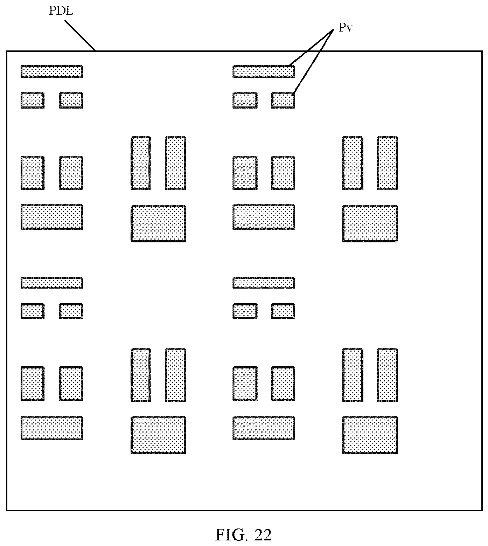

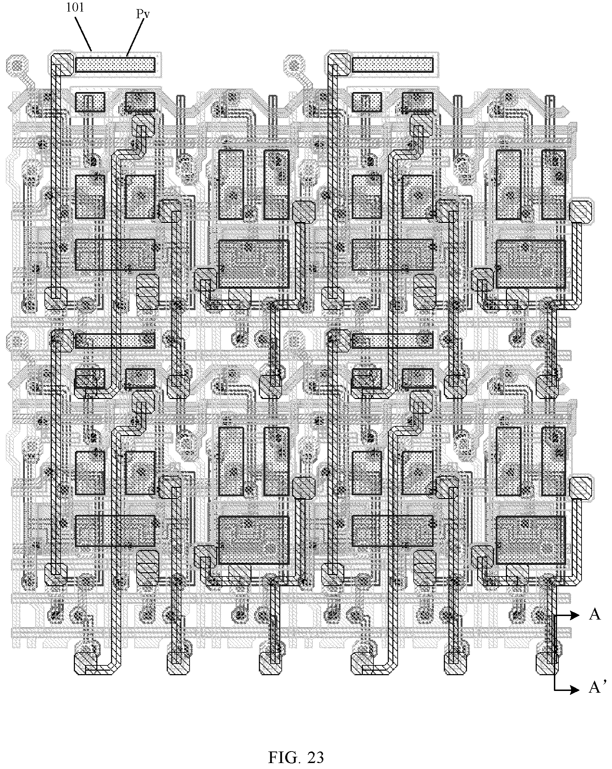

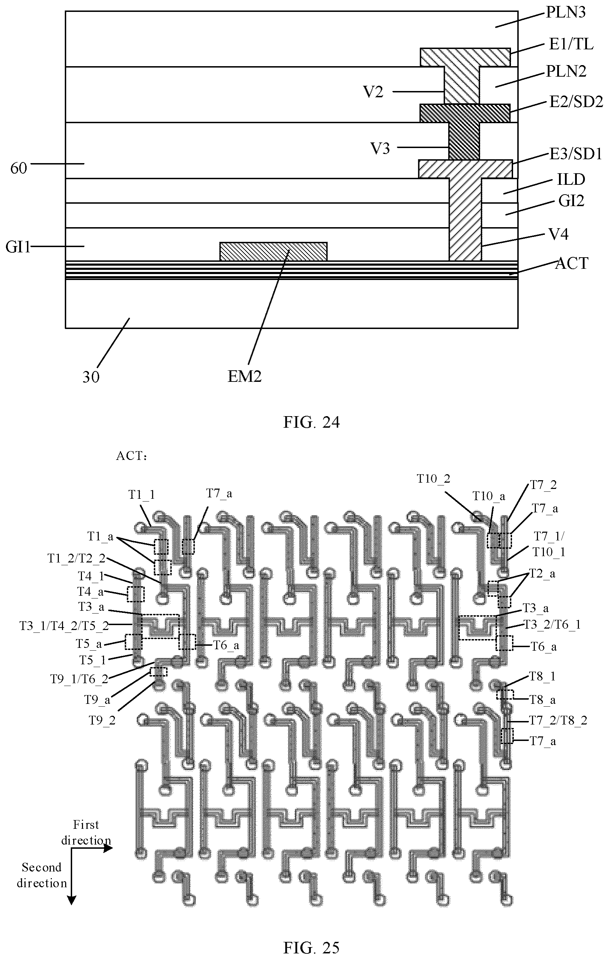

FIG. 14 is a schematic plan view of a semiconductor layer of a display panel according to some embodiments of the present disclosure. FIG. 15 is a schematic plan view of a first gate metal layer of a display panel according to some embodiments of the present disclosure. FIG. 16 is a schematic plan view of a second gate metal layer of a display panel according to some embodiments of the present disclosure. FIG. 17 is a schematic plan view of a first source-drain metal layer of a display panel according to some embodiments of the present disclosure. FIG. 18 is a schematic plan view of a second source-drain metal layer of a display panel according to some embodiments of the present disclosure. FIG. 19 is a schematic diagram of a stack of a semiconductor layer, a first gate metal layer, a second gate metal layer, a first source-drain metal layer, and a second source-drain metal layer of a display panel according to some embodiments of the present disclosure. FIG. 20 is a schematic plan view of a transparent conductive layer of a display panel according to some embodiments of the present disclosure. FIG. 21 is a schematic plan view of a first electrode layer of a display panel according to some embodiments of the present disclosure. FIG. 22 is a schematic plan view of a pixel defining layer of a display panel according to some embodiments of the present disclosure. FIG. 23 is an overall plan view of a pixel driving circuit and a first electrode layer, which are connected together, of a display panel according to some embodiments of the present disclosure. FIG. 24 is a cross-sectional view taken along a line A-A' of FIG. 23.

As shown in FIGS. 14 to 19, the control electrode T8_g of the eighth transistor T8 is electrically connected to the second luminescent control line EM2, and the second electrode T8_2 of the eighth transistor T8 is electrically connected to the first electrode 201 of one of the plurality of light-emitting devices 20. An orthographic projection of the eighth transistor T8 on the base substrate 30 and an orthographic projection of the driving transistor T3 on the base substrate 30 are located on two opposite sides of an orthographic projection of the first luminescent control line EM1 on the base substrate 30, respectively.

In some embodiments, as shown in FIGS. 14 to 24, the display panel includes a semiconductor layer ACT, a first gate metal layer G1, a second gate metal layer G2, a first source-drain metal layer SD1, a second source-drain metal layer SD2, a transparent conductive layer TL, a first electrode layer AND1, and a pixel defining layer PDL, which are sequentially disposed in a direction away from the base substrate 30.

As shown in FIG. 14, the semiconductor layer ACT is provided on the base substrate 30, and may be formed by patterning a semiconductor material, which may be a polysilicon material. The semiconductor layer ACT may include an active layer and doped region patterns of each transistor in the pixel driving circuit. For each transistor, the doped region patterns are provided on two opposite sides of the active layer of the transistor, and may be respectively used as the first electrode and the second electrode of the transistor. Active layers T1_a to T9_a of the transistors are shown in FIG. 14. It should be noted that in the embodiment of the present disclosure, a position of the active layer of each transistor represents a position of the transistor.

The second electrode T1_2 of the first transistor T1 and the second electrode T2_2 of the second transistor T2 have a one-piece structure. The first electrode T2_1 of the second transistor T2, the second electrode T3_2 of the driving transistor T3 and the first electrode T6_1 of the sixth transistor T6 have a one-piece structure. The second electrode T6_2 of the sixth transistor T6 and the first electrode T9_1 of the ninth transistor T9 have a one-piece structure. The second electrode T4_2 of the fourth transistor T4, the first electrode T3_1 of the driving transistor T3 and the second electrode T5_2 of the fifth transistor T5 have a one-piece structure. The second electrode T7_2 of the seventh transistor T7 and the second electrode T8_2 of the eighth transistor T8 have a one-piece structure.

In one example, an active layer T1_a, the first electrode T1_1, and the second electrode T1_2 of the first transistor T1 are connected together so that the first transistor T1 has an L-shaped structure, including a first extension portion extending in the first direction and a second extension portion extending in the second direction, at least a portion of the first electrode T1_1 of the first transistor T1 is located on the first extension portion, and the second electrode T1_2 of the first transistor T1 is located on the second extension portion.

In one example, in every two adjacent pixel driving circuits in the same column, an active layer T7_a of the seventh transistor T7 in the previous pixel driving circuit and the active layer T1_a of the first transistor T1 in the next pixel driving circuit are arranged substantially in the first direction.

In one example, the first transistor T1 is located on a side of the driving transistor T3 away from the eighth transistor T8.

In some embodiments, a first gate insulating layer GI1 is disposed between the semiconductor layer ACT and the first gate metal layer G1, and may be made of: silicon oxynitride (SiON), silicon oxide (SiOx), silicon nitride (SiNx), silicon oxycarbide (SiOxCy), silicon carbonitride (SiCxNy), aluminum oxide (AlOx), aluminum nitride (AlNx), tantalum oxide (TaOx), hafnium oxide (HfOx), zirconium oxide (ZrOx), or titanium oxide (TiOx), or the like. The first gate insulating layer GI1 may be formed as including a single layer or multiple layers.

In some embodiments, as shown in FIG. 15, the first gate metal layer G1 includes the control electrodes T1_g to T9_g of the transistors, and the first plate C11 of the storage capacitor Cst. The first plate C11 of the storage capacitor Cst is shared with the control electrode T3_g of the driving transistor T3. Both the first transistor T1 and the second transistor T2 may be double-gate transistors. The control electrode T2_g of the second transistor T2 and the control electrode T4_g of the fourth transistor T4 in the same pixel driving circuit may be separated from each other, and in every two adjacent pixel driving circuits in the same row, the control electrode T2_g of the second transistor T2 in one pixel driving circuit and the control electrode T4_g of the fourth transistor T4 in the other pixel driving circuit may have a one-piece structure. In every two adjacent pixel driving circuits in the same column, the control electrode T7_g of the seventh transistor T7 in the previous pixel driving circuit and the control electrode T1_g of the first transistor T1 in the next pixel driving circuit may have a one-piece structure.

In addition, the first gate metal layer G1 may further include: the first luminescent control line EM1, the second luminescent control line EM2, and the third luminescent control line EM3, all of which extend in the first direction. The third luminescent control line EM3 is located on a side of the first luminescent control line EM1 away from the driving transistor T3, the second luminescent control line EM2 is located on a side of the third luminescent control line EM3 away from the driving transistor T3. The control electrode T5_g of the fifth transistor T5, the control electrode T6_g of the sixth transistor T6 and the first luminescent control line EM1 have a one-piece structure, the control electrode T8_g of the eighth transistor T8 and the second luminescent control line EM2 have a one-piece structure, and the control electrode T9_g of the ninth transistor T9 and the third luminescent control line EM3 have a one-piece structure.

It should be noted that a signal line "extends in the first direction" (or "extends in the second direction") in the embodiment of the present disclosure, which does not necessarily mean that the signal line is necessarily a straight line, and the signal line may be bent to some extent as long as the signal line as a whole tends to extend in the first direction (or the second direction).

In some embodiments, the first gate metal layer G1 may be made of, for example, a metal, a metal alloy, a metal nitride, a conductive metal oxide, or a transparent conductive material, or the like. For example, the first gate metal layer G1 may be made of gold (Au), a gold alloy, silver (Ag), a silver alloy, aluminum (Al), an aluminum alloy, aluminum nitride (AlNx), tungsten (W), tungsten nitride (WNx), copper (Cu), a copper alloy, nickel (Ni), chromium (Cr), chromium nitride (CrNx), molybdenum (Mo), a molybdenum alloy, titanium (Ti), titanium nitride (TiNx), platinum (Pt), tantalum (Ta), tantalum nitride (TaNx), neodymium (Nd), scandium (Sc), strontium ruthenium oxide (SRO), zinc oxide (ZnOx), tin oxide (SnOx), indium oxide (InOx), gallium oxide (GaOx), indium tin oxide (ITO), or indium zinc oxide (IZO), or the like. The first gate metal layer G1 may have a single layer or multiple layers.

In some embodiments, a second gate insulating layer GI2 is disposed on a side of the first gate metal layer G1 away from the base substrate 30, and may be made of: silicon oxynitride (SiON), silicon oxide (SiOx), silicon nitride (SiNx), silicon oxycarbide (SiOxCy), silicon carbonitride (SiCxNy), aluminum oxide (AlOx), aluminum nitride (AlNx), tantalum oxide (TaOx), hafnium oxide (HfOx), zirconium oxide (ZrOx), or titanium oxide (TiOx), or the like. The second gate insulating layer GI2 may be formed as including a single layer or more layers.

In some embodiments, as shown in FIG. 16, the second gate metal layer G2 is disposed on a side of the second gate insulating layer GI2 away from the base substrate 30, and may include: the first initialization voltage line Vinit1, the second initialization voltage line Vinit2, and the second plate C12 of the storage capacitor Cst. The first initialization voltage line Vinit1 is located on a side of the second initialization voltage line Vinit2 away from the second plate C12, and may have a wavy structure extending in the first direction as a whole. The second initialization voltage line Vinit2 extends in the first direction as a whole, and includes a signal line body and a connection portion connected to the signal line body, the signal line body extends in the first direction, one end of the connection portion is connected to the signal line body, and the other end of the connection portion is connected to the first electrode T7_1 of the seventh transistor T7.

In some embodiments, an interlayer dielectric layer ILD is disposed on a side of the second gate metal layer G2 away from the base substrate 30, a material of the interlayer dielectric layer ILD may be selected from the materials of the first gate insulating layer GI1 and the second gate insulating layer GI2 listed above, and the interlayer dielectric layer ILD may include one layer or multiple layers.

In some embodiments, the first source-drain metal layer SD1 is disposed on a side of the interlayer dielectric layer ILD away from the base substrate 30, as shown in FIG. 17, the first source-drain metal layer SD1 includes: the first reset signal line Re1, the scan line GT, a third adapter electrode E3, a fourth adapter electrode E4, a seventh adapter electrode E7, an eighth adapter electrode E8, a ninth adapter electrode E9, a fifteenth adapter electrode E15, a sixteenth adapter electrode E16, and a first power supply sub-line Vddl.

The first reset signal line Re1 extends in the first direction, and the scan line GT has a bent structure extending in the first direction as a whole. The first power supply sub-line Vddl may include a power supply line body Vdda extending in the first direction and a power supply line connection portion Vddb, the power supply line connection portion Vddb and the power supply line body Vdda have a one-piece structure. The power supply line connection portion Vddb is electrically connected to the first electrode T5_1 of the fifth transistor T5 through a fifteenth via V15.

The first reset signal line Re1, the scan line GT, and the first power supply sub-line Vddl connected to the same pixel driving circuit are sequentially arranged in the second direction, the ninth adapter electrode E9 is located on a side of the first reset signal line Re1 away from the scan line GT, the eighth adapter electrode E8 and the fifteenth adapter electrode E15 are located between the scan line GT and the first reset signal line Re1, the sixteenth adapter electrode E16 is located between the scan line GT and the first power supply sub-line Vdd1, and the third adapter electrode E3, the fourth adapter electrode E4, and the seventh adapter electrode E7 are located on a side of the first power supply sub-line Vdd1 away from the scan line GT.

As shown in FIG. 17, the scan line GT may have a bent structure and extend in the first direction as a whole, and is electrically connected to the control electrode T4_g of the fourth transistor T4 through a thirty-second via V32. In every two adjacent pixel driving circuits in the same row, the control electrode T4_g of the fourth transistor T4 of one pixel driving circuit and the control electrode T2_g of the second transistor T2 of the other pixel driving circuit have a one-piece structure. Therefore, the scan line GT is electrically connected to the control electrode T4_g of the fourth transistor T4, so that the control electrodes T4_g of the fourth transistors T4 and the control electrodes T2_g of the second transistors T2 of the plurality of pixel driving circuits in the same row may all be connected to the scan line GT.

As shown in FIG. 17, the first reset signal line Re1 is electrically connected to the control electrode T1_g of the first transistor T1 through a seventeenth via V17. The first power supply sub-line Vddl is electrically connected to the second plate C12 of the storage capacitor Cst through a thirty-fifth via V35.

As shown in FIG. 17, the third adapter electrode E3 is electrically connected to the second electrode of the eighth transistor T8 through a fourth via V4, and is connected to the first electrode 201 of one of the light-emitting devices 20.

The fourth adapter electrode E4 is electrically connected to the first electrode T8_1 of the eighth transistor T8 through a fifth via V5, and is electrically connected to the second electrode T6_2 of the sixth transistor T6 through a sixth via V6, so that the second electrode T6_2 of the sixth transistor T6 is electrically connected to the first electrode T8_1 of the eighth transistor T8 through the fourth adapter electrode E4. Each pixel driving circuit corresponds to one fourth adapter electrode E4, and the fourth adapter electrodes E4 corresponding to the plurality of pixel driving circuits in the same row are arranged along the first direction.

One end of the seventh adapter electrode E7 is electrically connected to the second electrode T9_2 of the ninth transistor T9 through a tenth via V10, and the other end of the seventh adapter electrode E7 is electrically connected to the first electrode 201 of the second light-emitting device 22. In one example, the seventh adapter electrode E7 and the fourth adapter electrode E4 are arranged along the first direction, and the seventh adapter electrode E7 may have a stripe structure extending along the second direction.

The eighth adapter electrode E8 is electrically connected to the first electrode T7_1 of the seventh transistor T7 through an eleventh via V11 and is electrically connected to the second initialization voltage line Vinit2 through a twelfth via V12, so that a voltage signal through the second initialization voltage line Vinit2 is transmitted to the first electrode T7_1 of the seventh transistor T7.

Some of the plurality of eighth adapter electrodes E8 connected to the plurality of pixel driving circuits in the same row may be connected to a second initialization voltage supply line V2a, so that a voltage signal through the second initialization voltage supply line V2a is transmitted to the second initialization voltage line Vinit2. For example, the plurality of eighth adapter electrodes E8 connected to the plurality of pixel driving circuits in the same row include a plurality of first-type adapter electrodes E81 electrically connected to the second initialization voltage supply line V2a and a plurality of second-type adapter electrodes E82.

In some embodiments, as shown in FIG. 17, the ninth adapter electrode E9 is electrically connected to the first electrode T1_1 of the first transistor T1 through an eighteenth via V18 and is electrically connected to the first initialization voltage line Vinit1 through a nineteenth via V19, so that the first electrode of the first transistor T1 is electrically connected to the first initialization voltage line Vinit1 through the ninth adapter electrode E9.

In some embodiments, ninth adapter electrodes E9 connected to pixel driving circuits in a same row include a plurality of third-type adapter electrodes E91 and a plurality of fourth-type adapter electrodes E92. An orthographic projection of each third-type adapter electrode E91 on the base substrate 30 overlaps with an orthographic projection of a corresponding first initialization voltage supply line V1a on the base substrate 30, and the third-type adapter electrode E91 is electrically connected to the corresponding first initialization voltage line Vinit1 through the nineteenth via V19. An orthographic projection of each fourth-type adapter electrode E92 on the base substrate 30 overlaps with an orthographic projection of a corresponding first initialization voltage line Vinitl on the base substrate 30, but does not overlap with the orthographic projection of the first initialization voltage supply line V1a on the base substrate 30. At least one fourth-type adapter electrode E92 is arranged between every two adjacent third-type adapter electrodes E91 arranged along the first direction.

The third-type adapter electrode E91 may be electrically connected to the first initialization voltage supply line V1a, so that a voltage signal through the first initialization voltage supply line V1a is transmitted to the first initialization voltage line Vinit1.

The orthographic projection of the third-type adapter electrode E91 on the base substrate 30 may overlap with an orthographic projection of the second luminescent control line EM2 on the base substrate 30.

In some embodiments, as shown in FIG. 17, the fifteenth adapter electrode E15 is configured to connect the data line DL and the first electrode T4_1 of the fourth transistor T4, so that a data signal is transmitted to the fourth transistor T4.

As shown in FIG. 17, the sixteenth adapter electrode E16 is electrically connected to the control electrode T3_g of the driving transistor T3 through a thirty-third via V33, and is electrically connected to the second electrode T2_2 of the second transistor T2 through a thirty-fourth via V34, thereby realizing the electrical connection between the control electrode T3_g of the driving transistor T3 and the second electrode T2_2 of the second transistor T2.

As shown in FIGS. 16 and 17, the second plate C12 of the storage capacitor Cst has an avoidance notch H0 located in the middle or at an edge of the second plate, and an edge of the avoidance notch H0 is located at a periphery of the thirty-third via V33, so that an orthographic projection of the second plate C12 on the base substrate 30 does not overlap with an orthographic projection of the thirty-third via V33 on the base substrate 30, and the second plate is prevented from being short-circuited with the control electrode T3_g of the driving transistor T3 (i.e., the first plate C11).

In some embodiments, in every two adjacent rows of pixel driving circuits, the second reset signal line Re2 connected to the pixel driving circuits in the previous row is shared with the first reset signal line Re1 connected to the pixel driving circuits in the next row.

In some embodiments, the orthographic projection of the first initialization voltage line Vinit1 is located on a side of an orthographic projection of the second initialization voltage line Vinit2 away from an orthographic projection of the first reset signal line Re1. An orthographic projection of each signal line is an orthographic projection of the signal line on the base substrate 30.

In some embodiments, as shown in FIG. 24, an insulating spacer layer 60 is located on a side of the first source-drain metal layer SD1 away from the base substrate 30, and may include at least one of a passivation layer and a first planarization layer. For example, the insulating spacer layer 60 may include only the passivation layer. Alternatively, the insulating spacer layer 60 may include only the first planarization layer. Alternatively, the insulating spacer layer 60 may include the passivation layer and the first planarization layer located on a side of the passivation layer away from the base substrate 30. A material of the passivation layer may be selected from the materials of the first gate insulating layer GI1 listed above, and will not be described herein again. The first planarization layer may be made of an organic insulating material, including, for example, a resin-based material, such as polyimide, epoxy, acryl, polyester, photoresist, polyacrylate, polyamide, or siloxane, or the like. The passivation layer may have a single layer or multiple layers.

In some embodiments, the second source-drain metal layer SD2 is located on a side of the insulating spacer layer 60 away from the base substrate 30, and a material of the second source-drain metal layer SD2 may be selected from the materials of the first gate metal layer G1 listed above. Alternatively, besides the materials of the first gate metal layer G1 listed above, the second source-drain metal layer SD2 may be made of a molybdenum/titanium alloy or a stack, and the stack may be, for example, a titanium/aluminum/titanium stack.

As shown in FIG. 18, the second source-drain metal layer SD2 may include: the data line DL, the first initialization voltage supply line V1a, the second initialization voltage supply line V2a, a second power supply sub-line Vdd2, and the second power supply line VSS. Each signal line extends in the second direction. The first initialization voltage supply line V1a is connected to the first initialization voltage line Vinit1, and is configured to provide a first initialization voltage signal to the first initialization voltage line Vinit1. The second initialization voltage supply line V2a is connected to the second initialization voltage line Vinit2 and is configured to provide the second initialization voltage signal to the second initialization voltage line Vinit2. A plurality of the first initialization voltage supply lines V1a and a plurality of the second initialization voltage supply lines V2a may be included, so that each first initialization voltage line Vinit1 may be electrically connected to the plurality of first initialization voltage supply lines V1a at multiple positions, respectively, and each second initialization voltage line Vinit2 may be electrically connected to the plurality of second initialization voltage supply lines V2a at multiple positions, respectively, and therefore, the voltage distribution on each first initialization voltage supply line Vinit1 and each second initialization voltage supply line Vinit2 is more uniform.

As shown in FIGS. 17 to 18, the second initialization voltage supply line V2a is electrically connected to the eighth adapter electrode E8 through a thirteenth via V13. The eighth adapter electrode E8 is electrically connected to the second initialization voltage line Vinit2 through the twelfth via V12, so that a voltage signal through the second initialization voltage supply line V2a may be transmitted to the second initialization voltage line Vinit2 by means of the eighth adapter electrode E8. In one example, as shown in FIG. 17, the plurality of eighth adapter electrodes E8 connected to the pixel driving circuits in the same row include the plurality of first-type adapter electrodes E81 and the plurality of second-type adapter electrodes E82, and an orthographic projection of the second initialization voltage supply line V2a on the base substrate 30 overlaps with an orthographic projection of the corresponding first-type adapter electrode E81 on the base substrate 30, so that the second initialization voltage supply line V2a is electrically connected to the corresponding first-type adapter electrode E81 through the thirteenth via V13. An orthographic projection of the second initialization voltage supply line V2a on the base substrate 30 may not overlap with an orthographic projection of the corresponding second-type adapter electrode E82 on the base substrate 30, and the second initialization voltage supply line V2a and the corresponding second-type adapter electrode E82 are not directly connected to each other.

As shown in FIG. 18, the first initialization voltage supply line V1a is electrically connected to the ninth adapter electrode E9 through a twentieth via V20. The ninth adapter electrode E9 is electrically connected to the first initialization voltage line Vinit1 through a nineteenth via V19, so that a voltage signal through the first initialization voltage supply line V1a may be transmitted to the first initialization voltage line Vinit1 by means of the ninth adapter electrode E9. In one example, as shown in FIG. 17, the plurality of ninth adapter electrodes E9 connected to the same row of pixel driving circuits includes a plurality of third-type adapter electrodes E91 and a plurality of fourth-type adapter electrodes E92. An orthographic projection of the first initialization voltage supply line V1a on the base substrate 30 overlaps with an orthographic projection of the corresponding third-type adapter electrode E91 on the base substrate 30, so that the first initialization voltage supply line V1a is electrically connected to the corresponding third-type adapter electrode E91 through the twentieth via V20. An orthographic projection of the first initialization voltage supply line V1a on the base substrate 30 may not overlap with an orthographic projection of the corresponding fourth-type adapter electrode E92 on the base substrate 30, and the first initialization voltage supply line V1a and the corresponding fourth-type adapter electrode E92 are not directly connected to each other.

As shown in FIGS. 17 and 18, the first power supply line VDD includes a plurality of first power supply sub-lines Vddl and a plurality of second power supply sub-lines Vdd2, which are cross-connected to each other to form a mesh structure, so that a voltage drop of the first power supply line VDD can be reduced, which is beneficial to display uniformity.

In some embodiments, each second power supply sub-line Vdd2 is connected to the corresponding first power supply sub-line Vddl through a sixteenth via V16, and the first power supply sub-line Vddl is electrically connected to the first electrode of the fifth transistor T5 through the fifteenth via V15. For example, each second power supply sub-line Vdd2 is electrically connected to the power supply line body Vdda of the corresponding first power supply sub-line Vddl through a sixteenth via V16, and the power supply line connection portion Vddb of the first power supply sub-line Vddl is electrically connected to the first electrode T5_1 of the fifth transistor T5 through the fifteenth via V15.

In some embodiments, an orthographic projection of the second power supply sub-line Vdd2 on the base substrate 30 may overlap with an orthographic projection of an active layer of at least one transistor on the base substrate 30, so as to reduce a leakage current for the transistor due to the transistor being illuminated, and improve electrical characteristics of the transistor. For example, an orthographic projection of the second power supply sub-line Vdd2 on the base substrate 30 overlaps with an orthographic projection of the active layer T1_a of the first transistor T1 on the base substrate 30 and an orthographic projection of the active layer T3_a of the driving transistor T3 on the base substrate 30.

The second power supply line VSS is electrically connected to the second electrode of each light-emitting device 20. For example, the second electrode of the light-emitting device 20 extends to a peripheral region where the second electrode of the light-emitting device 20 is connected to the second power supply line VSS through a via.

In some embodiments, an orthographic projection of the data line DL on the base substrate 30 overlaps with an orthographic projection of the fifteenth adapter electrode E15 on the base substrate 30, the data line DL is electrically connected to the fifteenth adapter electrode E15 through a thirtieth via V30, and the fifteenth adapter electrode E15 is electrically connected to the first electrode T4_1 of the fourth transistor T4 through a thirty-first via V31.

In some embodiments, as shown in FIG. 18, a plurality of data lines DL includes a first data line DL1, a second data line DL2, and a third data line DL3, each column of pixel driving circuits is electrically connected to one data line DL, a first side of each data line DL is adjacent to the second power supply sub-line Vdd2, a second side of the first data line DL1 is adjacent to the first initialization voltage supply line V1a, a second side of the second data line DL2 is adjacent to the second power supply line VSS, and a second side of the third data line DL3 is adjacent to the second initialization voltage supply line V2a. In this case, as shown in FIG. 17, two second-type adapter electrodes E82 are provided between every adjacent two first-type adapter electrodes E81 arranged in the first direction, and two fourth-type adapter electrodes E92 are arranged between every two adjacent third-type adapter electrodes E91 arranged in the first direction.

In some embodiments, as shown in FIG. 18, each data line DL includes a transmission portion DLb and a protruding portion DLa electrically connected to the fifteenth adapter electrode E15 through the thirtieth via V30, a diameter of the protruding portion DLa is greater than that of the transmission portion DLb, and each of the first initialization voltage supply line V1a, the second initialization voltage supply line V2a, the second power supply sub-line Vdd2, and the second power supply line VSS is provided with an indented portion at a position corresponding to the protruding portion DLa.

In addition, as shown in FIG. 18, the second source-drain metal layer SD2 further includes: a second adapter electrode E2 and a sixth adapter electrode E6, the second adapter electrode E2 is electrically connected to the third adapter electrode E3 through a via, and the sixth adapter electrode E6 is electrically connected to the seventh adapter electrode E7 through a via, and further electrically connected to the second electrode T9_2 of the ninth transistor T9 through the seventh adapter electrode E7.

The first power supply sub-line Vddl includes a first recess Va and a second recess Vb at edges of the first power supply sub-line Vddl on two opposite sides, respectively, the second adapter electrode E2 is disposed in the first recess Va, and the sixth adapter electrode E6 is disposed in the second recess Vb.

In some embodiments, as shown in FIG. 24, a second planarization layer PLN2 is disposed on a side of the second source-drain metal layer SD2 away from the base substrate 30, and a material of the second planarization layer PLN2 may include an organic insulating material, and may be specifically selected from the materials of the first planarization layer listed above.

In some embodiments, the transparent conductive layer TL is located on a side of the second planarization layer PLN2 away from the base substrate 30. The transparent conductive layer TL may be made of a transparent material such as indium tin oxide (ITO) or indium zinc oxide (IZO) or the like. As shown in FIG. 20, the transparent conductive layer TL may include a plurality of first adapter electrodes E1 and a plurality of fifth adapter electrodes E5. The first electrode 201 of one of the two light-emitting devices 20 connected to each pixel driving circuit is electrically connected to the corresponding first adapter electrode E1, and the first electrode 201 of the other light-emitting device 20 is electrically connected to the corresponding fifth adapter electrode E5.

In some embodiments, as shown in FIG. 24, a third planarization layer PLN3 is disposed on a side of the transparent conductive layer TL away from the base substrate 30, and a material of the third planarization layer PLN3 may include an organic insulating material, and may be selected from the materials of the first planarization layer listed above.

In some embodiments, as shown in FIGS. 21 and 24, the first electrode layer AND1 is disposed on a side of the third planarization layer PLN3 away from the base substrate 30, and may be made of a transparent material such as indium tin oxide (ITO) or indium zinc oxide (IZO).

As shown in FIG. 21, the first electrode layer AND1 includes the first electrode 201 of each light-emitting device 20. As shown in FIGS. 14 to 24, in the two light-emitting devices 20 connected to each pixel driving circuit, the first electrode 201 of one light-emitting device 20 is electrically connected to the first adapter electrode E1 through a first via V1, the first adapter electrode E1 is electrically connected to the second adapter electrode E2 through a second via V2, the second adapter electrode E2 is electrically connected to the third adapter electrode E3 through a third via V3, and the third adapter electrode E3 is electrically connected to the second electrode of the eighth transistor T8 through a fourth via V4, so that the first electrode 201 of the one light-emitting device 20 is electrically connected to the second electrode T8_2 of the eighth transistor T8 through the first adapter electrode E1, the second adapter electrode E2 and the third adapter electrode E3. For example, in FIGS. 14 to 24, the electrical connection between the first electrode 201 of the first light-emitting device 21 and the second electrode T8_2 of the eighth transistor T8 is achieved through the first adapter electrode E1, the second adapter electrode E2 and the third adapter electrode E3.

As shown in FIGS. 14 to 24, the first electrode 201 of the second light-emitting device 22 is electrically connected to the fifth adapter electrode E5 through a seventh via V7, the fifth adapter electrode E5 is electrically connected to the sixth adapter electrode E6 through an eighth via V8, the sixth adapter electrode E6 is electrically connected to the seventh adapter electrode E7 through a ninth via V9, and the seventh adapter electrode E7 is electrically connected to the second electrode of the ninth transistor T9 through a tenth via V10.

The display panel further includes the pixel defining layer PDL located on a side of the first electrodes 201 of the light-emitting devices 20 away from the base substrate 30. The pixel defining layer PDL has pixel openings Pv therein, each pixel opening Pv exposes at least a portion of the corresponding first electrode 201, and a luminescent functional layer of each light-emitting device 20 is at least partially located in the corresponding pixel opening Pv. Each of some of the light-emitting devices 20 connected to the pixel driving circuit corresponds to pixel openings Pv, and each of the remaining light-emitting devices 20 corresponds to one pixel opening Pv. For example, the first light-emitting device 21 corresponds to one pixel opening Pv, and the second light-emitting device 22 corresponds to two pixel openings Pv.

A black matrix may be provided on a side of the pixel defining layer PDL away from the base substrate 30, and at least a portion of an orthographic projection of the black matrix on the base substrate 30 does not overlap with an orthographic projection of the pixel opening Pv on the base substrate 30. Each of some light-emitting devices 20 corresponds to the pixel openings Pv, so that a light-outgoing angle of each light-emitting device 20 is advantageously reduced, and the peep-proof effect of the display panel in the peep-proof mode is improved.

In one example, the light-emitting devices 20 connected to the same pixel driving circuit emit light of the same color, e.g., red, green, blue or white. The plurality of light-emitting devices 20 of the display panel are divided into a plurality of repeating units, each of which includes light-emitting devices 20 connected to a plurality of pixel driving circuits. For example, each repeating unit includes light-emitting devices 20 connected to three pixel driving circuits. The light-emitting devices 20 connected to the three pixel driving circuits emit red light, green light, and blue light, respectively.

In other embodiments, the pixel driving circuit employs the structure in FIG. 8. In this case, layouts of the layers in the display panel are shown in FIG. 25 to FIG. 34. In the embodiment of the present disclosure, as an example, the pixel driving circuits are arranged in an array, and are arranged in a plurality of rows along the second direction and in a plurality of columns along the first direction.

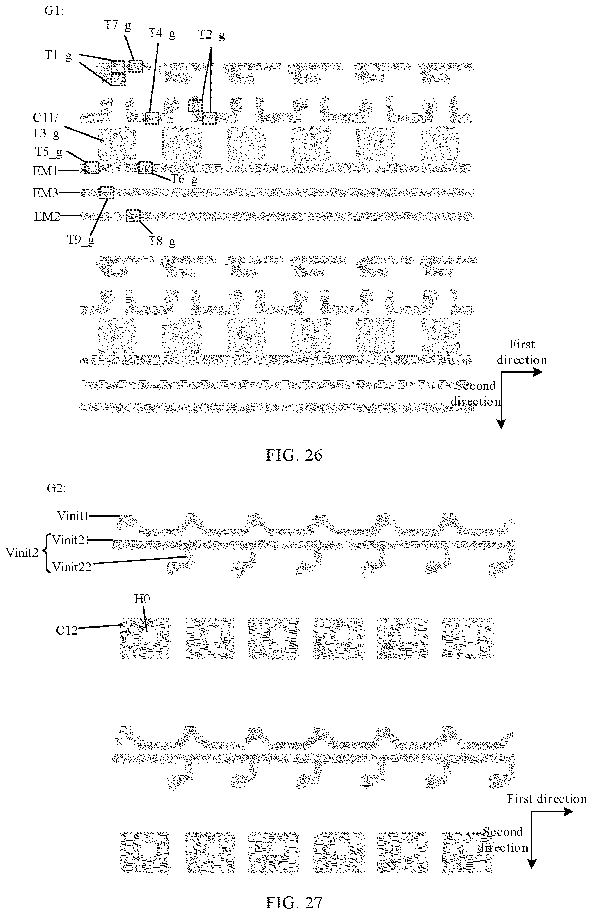

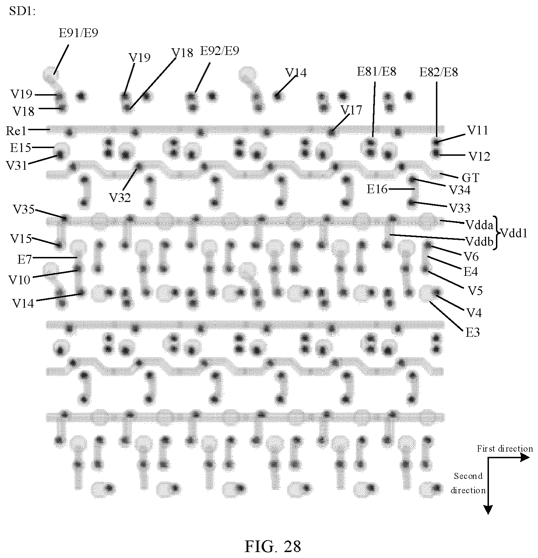

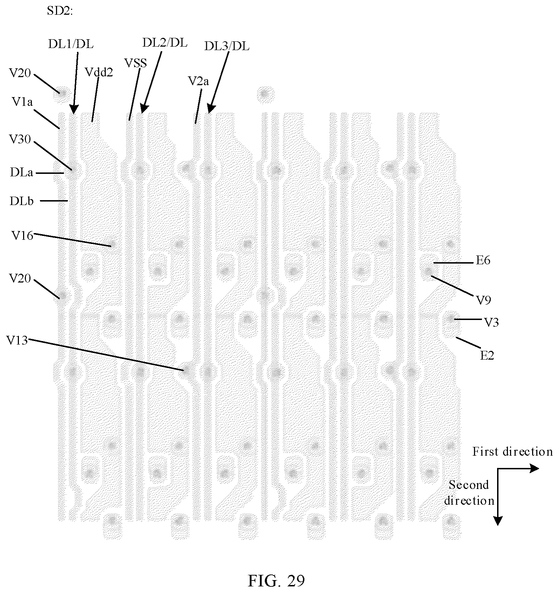

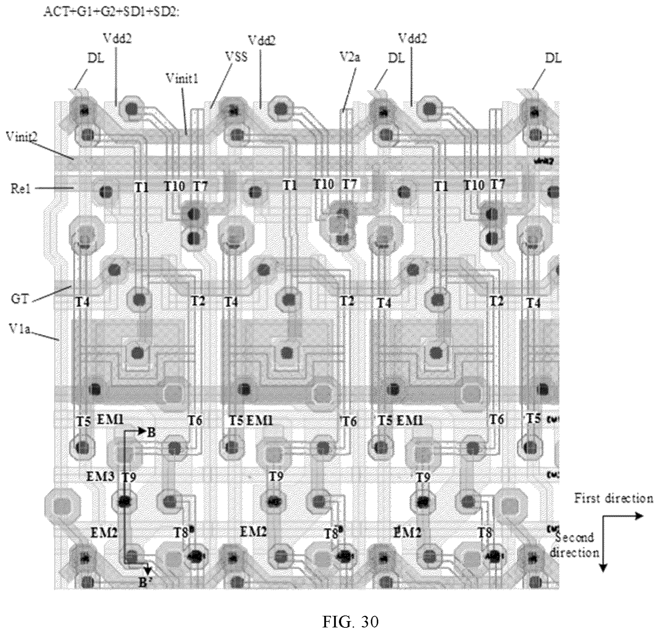

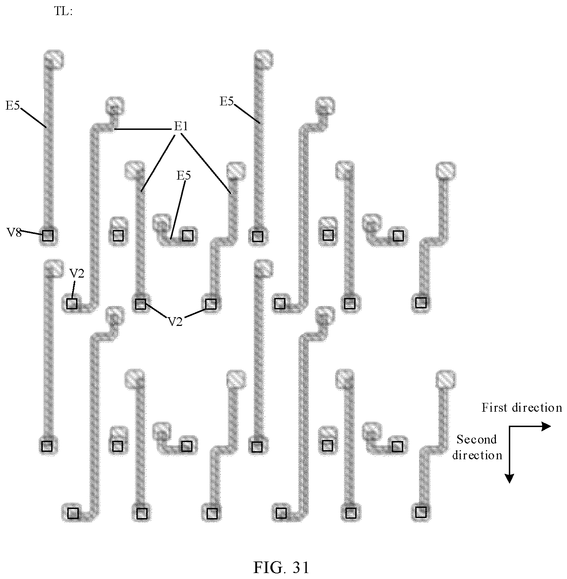

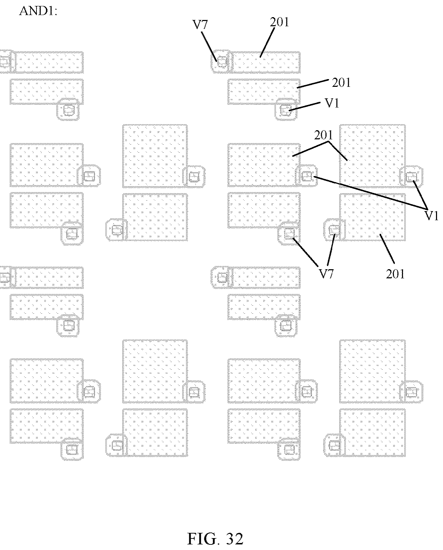

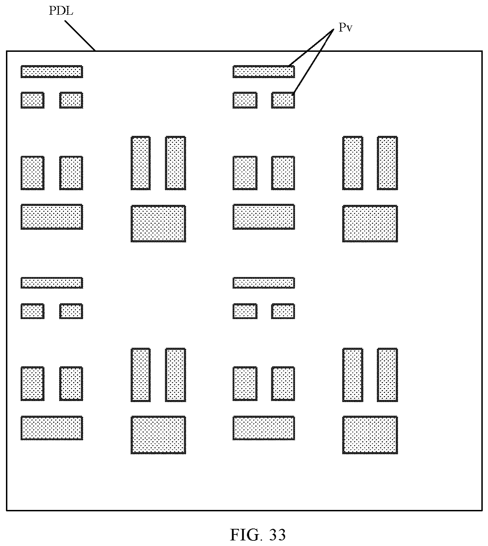

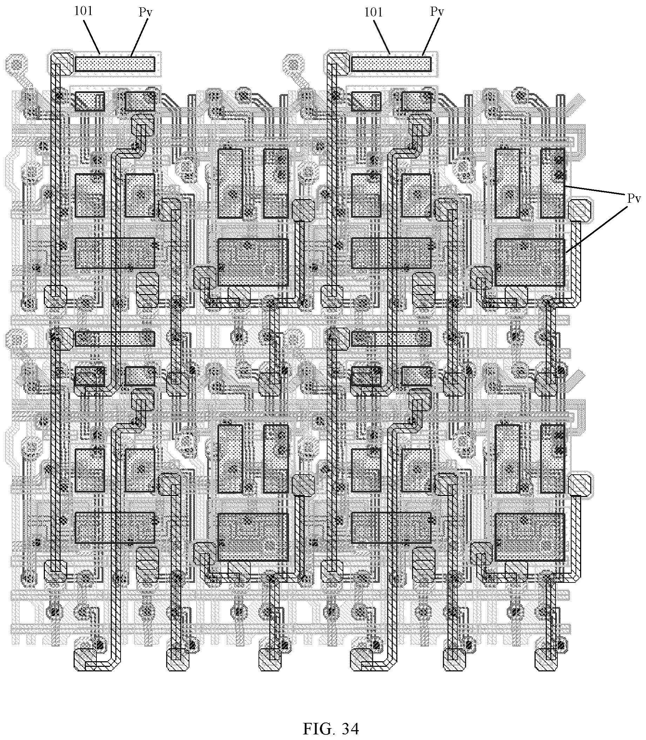

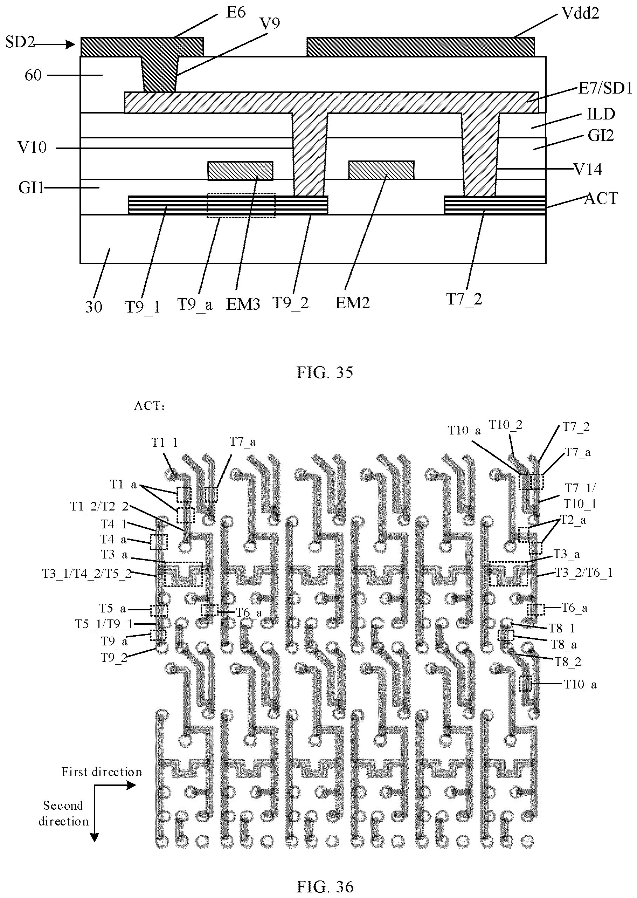

FIG. 25 is a schematic plan view of a semiconductor layer of a display panel according to further embodiments of the present disclosure. FIG. 26 is a schematic plan view of a first gate metal layer of a display panel according to further embodiments of the present disclosure. FIG. 27 is a schematic plan view of a second gate metal layer of a display panel according to further embodiments of the present disclosure. FIG. 28 is a schematic plan view of a first source-drain metal layer of a display panel according to further embodiments of the present disclosure. FIG. 29 is a schematic plan view of a second source-drain metal layer of a display panel according to further embodiments of the present disclosure. FIG. 30 is a schematic diagram of a stack of a semiconductor layer, a first gate metal layer, a second gate metal layer, a first source-drain metal layer, and a second source-drain metal layer of a display panel according to further embodiments of the present disclosure. FIG. 31 is a schematic plan view of a transparent conductive layer of a display panel according to further embodiments of the present disclosure. FIG. 32 is a schematic plan view of a first electrode layer of a display panel according to further embodiments of the present disclosure. FIG. 33 is a schematic plan view of a pixel defining layer of a display panel according to further embodiments of the present disclosure. FIG. 34 is an overall plan view of a pixel driving circuit and a first electrode layer, which are connected together, of a display panel according to further embodiments of the present disclosure. FIG. 35 is a cross-sectional view taken along a line B-B' of FIG. 30.

As shown in FIGS. 25 to 34, the control electrode T8_g of the eighth transistor T8 is electrically connected to the second luminescent control line EM2, and the second electrode of the eighth transistor T8 is electrically connected to the first electrode 201 of one of the plurality of light-emitting devices 20. An orthographic projection of the eighth transistor T8 on the base substrate 30 and an orthographic projection of the driving transistor T3 on the base substrate 30 are located on two opposite sides of an orthographic projection of the first luminescent control line EM1 on the base substrate 30, respectively.

In some embodiments, as shown in FIGS. 25 to 35, the display panel includes a semiconductor layer ACT, a first gate metal layer G1, a second gate metal layer G2, a first source-drain metal layer SD1, a second source-drain metal layer SD2, a transparent conductive layer TL, a first electrode layer AND1, and a pixel defining layer PDL, which are sequentially disposed in a direction away from the base substrate 30.

As shown in FIG. 25, the semiconductor layer ACT is provided on the base substrate 30, and the semiconductor layer ACT layer in FIG. 25 includes the active layer and the doped region patterns of each transistor in the pixel driving circuit shown in FIG. 8. For each transistor, the doped region patterns are provided on two opposite sides of the active layer of the transistor, and may be respectively used as the first electrode and the second electrode of the transistor. Active layers T1_a to T10_a of the transistors are shown in FIG. 25.

A pattern of the semiconductor layer ACT shown in FIG. 25 is similar to that of the semiconductor layer ACT shown in FIG. 14, except that the semiconductor layer ACT shown in FIG. 25 further includes the active layer T7_a, the first electrode T7_1, and the second electrode T7_2 of the seventh transistor T7. The active layer T7_a of the seventh transistor T7 and the active layer T10_a of the tenth transistor T10 are arranged along the first direction, and the active layer T7_a of the seventh transistor T7 is located on a side of the active layer T10_a of the tenth transistor T10 away from the active layer T1_a of the first transistor T1. The first electrode T7_1 of the seventh transistor T7 and a first electrode T10_1 of the tenth transistor T10 have a one-piece structure.

For the other structure of the semiconductor layer ACT in FIG. 25, reference is made to the description for FIG. 14, and it is not described again here.

In FIGS. 25 to 35, a first gate insulating layer GI1 is disposed between the semiconductor layer ACT and the first gate metal layer G1, and for the material of the first gate insulating layer GI1, reference is made to the description in the above embodiments.

In FIGS. 25 to 35, the first gate metal layer G1 is disposed on a side of the first gate insulating layer GI1 away from the base substrate 30. As shown in FIG. 26, the first gate metal layer G1 includes: the first luminescent control line EM1, the second luminescent control line EM2, and the third luminescent control line EM3. The first gate metal layer G1 further includes control electrodes T1_g to T10_g of the transistors. The specific pattern structure of the first gate metal layer G1 is similar to that in FIG. 15, except that in FIG. 26, the first gate metal layer G1 further includes the control electrode T10_g of the tenth transistor T10, and the control electrode T10_g of the tenth transistor T10 and the control electrode T7_g of the seventh transistor T7 have a one-piece structure. In addition, in every two adjacent pixel driving circuits in the same column, the control electrode T7_g of the seventh transistor T7 and the control electrode T10_g of the tenth transistor T10 in the previous pixel driving circuit and the control electrode T10_g of the tenth transistor T10 in the next pixel driving circuit have a one-piece structure.

In FIG. 25 to FIG. 35, a second gate insulating layer GI2 is disposed on a side of the first gate metal layer G1 away from the base substrate 30, and for the material of the second gate insulating layer GI2, reference is made to the description in the above embodiments and it is not described again here.

In FIGS. 25 to 35, the second gate metal layer G2 is disposed on a side of the second gate insulating layer GI2 away from the base substrate 30, and may include: the first initialization voltage line Vinit1, the second initialization voltage line Vinit2, and the second plate C12 of the storage capacitor Cst. The first initialization voltage line Vinit1 is located on a side of the second initialization voltage line Vinit2 away from the second plate C12, and may have a wavy structure extending in the first direction as a whole. The second initialization voltage line Vinit2 extends in the first direction as a whole, and includes a signal line body Vinit21 and a connection portion Vinit22 connected to the signal line body Vinit21, the signal line body Vinit21 extends in the first direction, and one end of the connection portion Vinit22 is connected to the signal line body Vinit21.

As shown in FIG. 25 to FIG. 35, an interlayer dielectric layer ILD is disposed on a side of the second gate metal layer G2 away from the base substrate 30, and for the material of the interlayer dielectric layer ILD, reference is made to the description in the above embodiments.

As shown in FIG. 25 to FIG. 35, the first source-drain metal layer SD1 is disposed on a side of the interlayer dielectric layer ILD away from the base substrate 30, and includes: the first reset signal line Re1, the scan line GT, a third adapter electrode E3, a fourth adapter electrode E4, a seventh adapter electrode E7, an eighth adapter electrode E8, a ninth adapter electrode E9, a fifteenth adapter electrode E15, a sixteenth adapter electrode E16, and a first power supply sub-line Vddl.

In FIG. 28, the seventh adapter electrode E7 extends substantially along the second direction, and a length of the seventh adapter electrode E7 in FIG. 28 may be greater than that of the seventh adapter electrode E7 in FIG. 17. In addition, unlike the seventh adapter electrode E7 in FIG. 17, in FIG. 28, the seventh adapter electrode E7 is electrically connected to the second electrode T10_2 of the tenth transistor T10 in addition to being electrically connected to the second electrode T9_2 of the ninth transistor T9 and the first electrode 201 of the second light-emitting device 22. For example, one end of the seventh adapter electrode E7 away from the first power supply sub-line Vdd1 is electrically connected to the second electrode T10_2 of the tenth transistor T10 through a fourteenth via V14, a middle portion of the seventh adapter electrode E7 is electrically connected to the second electrode T9_2 of the ninth transistor T9 through a tenth via V10, and one end of the seventh adapter electrode E7 close to the first power supply sub-line Vddl is connected to the first electrode 201 of the second light-emitting device 22.

For the connection of the structures other than the seventh adapter electrode E7 in FIG. 28, reference is made to the above description for FIG. 17 and it is not described again here.

As shown in FIG. 25 to FIG. 35, an insulating spacer layer 60 is located on a side of the first source-drain metal layer SD1 away from the base substrate 30, and for a specific material of the insulating spacer layer 60, reference is made to the description in the above embodiments and it is not described again here.

The second source-drain metal layer SD2 is disposed on a side of the insulating spacer layer 60 away from the base substrate 30, and a material and a structure of the second source-drain metal layer SD2 may be the same as those of the second source-drain metal layer SD2 in FIG. 18, and are not described herein again.

As shown in FIG. 25 to FIG. 35, a second planarization layer is disposed on a side of the second source-drain metal layer SD2 away from the base substrate 30, the transparent conductive layer TL is disposed on a side of the second planarization layer away from the base substrate 30, a third planarization layer is disposed on a side of the transparent conductive layer TL away from the base substrate 30, the first electrode layer AND1 is disposed on a side of the third planarization layer away from the base substrate 30, and the first electrode layer AND1 includes the first electrodes 201 of the light-emitting devices 20. The pixel defining layer PDL is located on a side of the first electrodes 201 of the light-emitting devices 20 away from the base substrate 30. For materials and structures of the second planarization layer, the transparent conductive layer TL, the third planarization layer, the first electrode layer AND1, and the pixel defining layer, reference may be made to the above description for FIGS. 17 to 24 and it is not described again here.

In still other embodiments, the pixel driving circuit employs the structure in FIG. 10. In this case, layouts of the layers in the display panel are shown in FIG. 36 to FIG. 46. In the embodiment of the present disclosure, as an example, the pixel driving circuits are arranged in an array, and are arranged in a plurality of rows along the second direction and in a plurality of columns along the first direction.

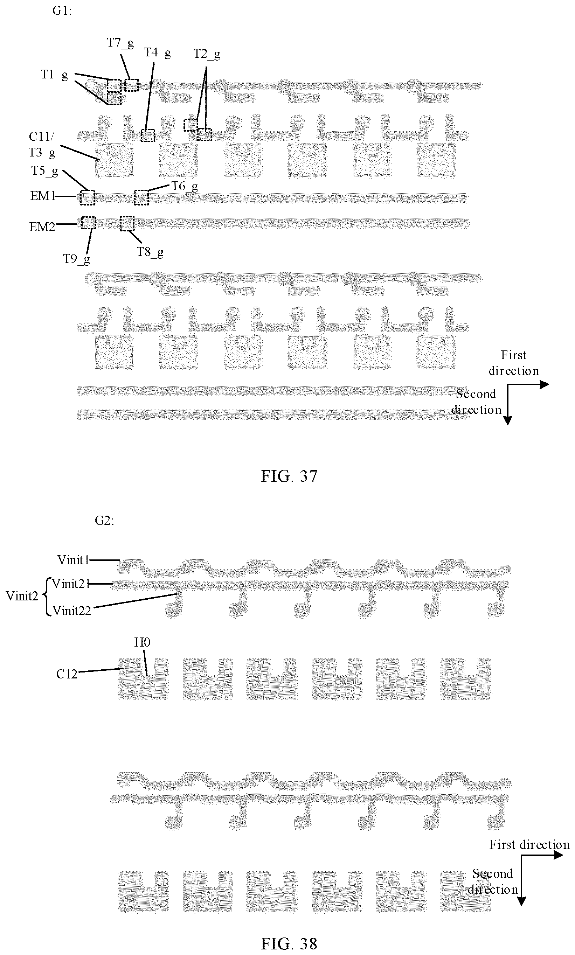

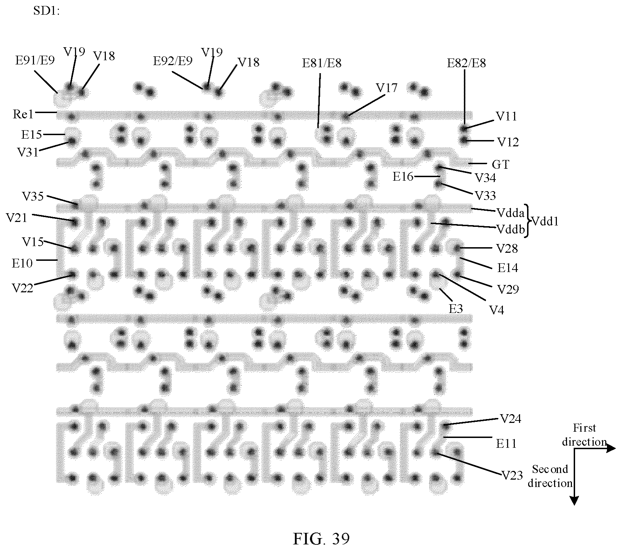

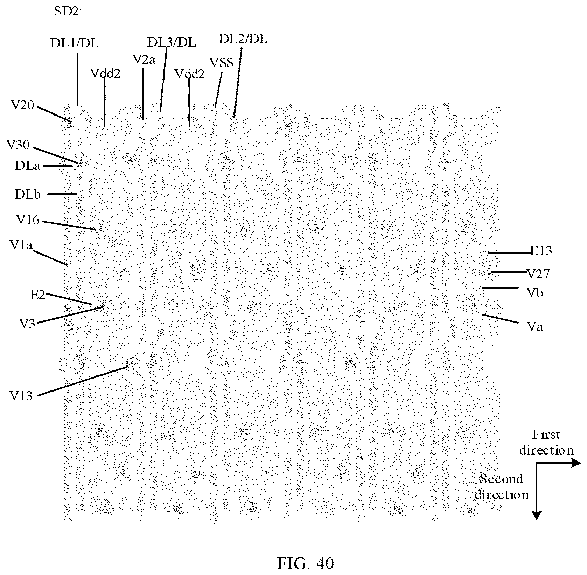

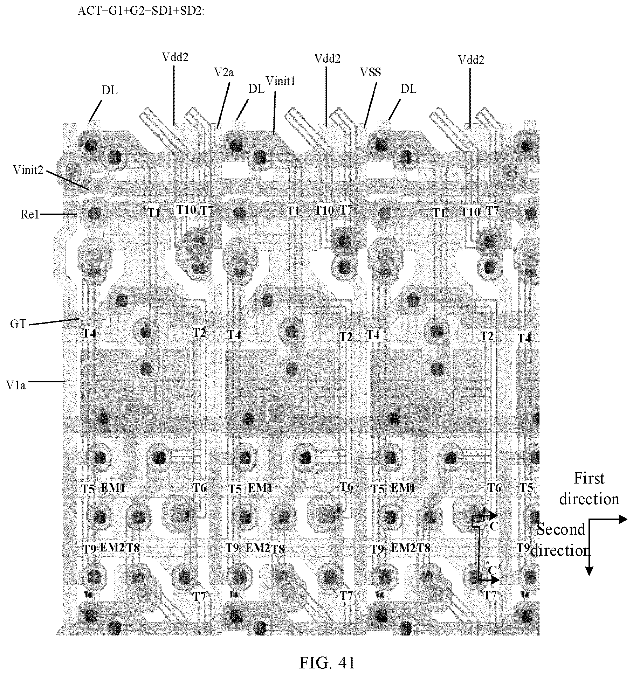

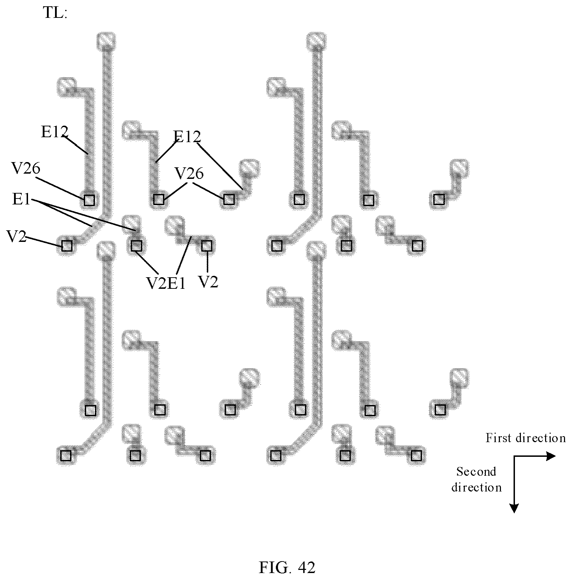

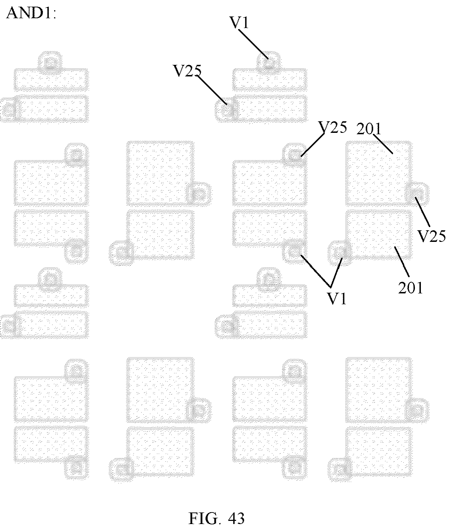

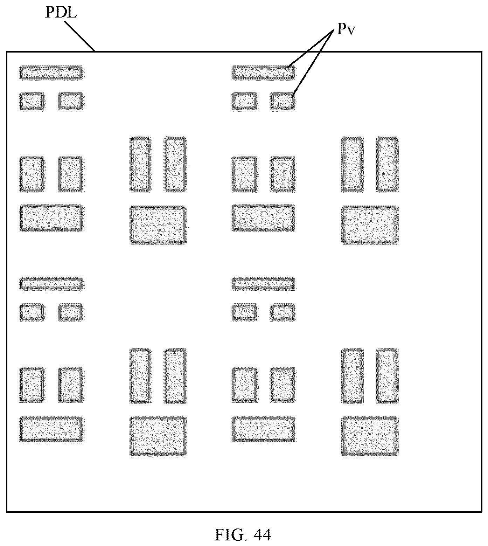

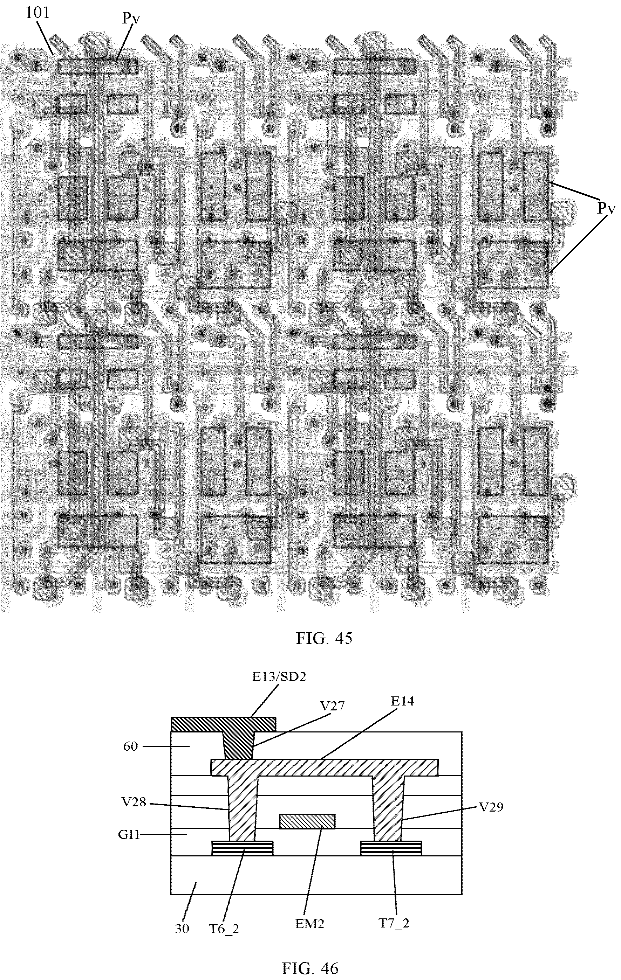

FIG. 36 is a schematic plan view of a semiconductor layer of a display panel according to further embodiments of the present disclosure. FIG. 37 is a schematic plan view of a first gate metal layer of a display panel according to further embodiments of the present disclosure. FIG. 38 is a schematic plan view of a second gate metal layer of a display panel according to further embodiments of the present disclosure. FIG. 39 is a schematic plan view of a first source-drain metal layer of a display panel according to further embodiments of the present disclosure. FIG. 40 is a schematic plan view of a second source-drain metal layer of a display panel according to further embodiments of the present disclosure. FIG. 41 is a schematic diagram of a stack of a semiconductor layer, a first gate metal layer, a second gate metal layer, a first source-drain metal layer, and a second source-drain metal layer of a display panel according to further embodiments of the present disclosure. FIG. 42 is a schematic plan view of a transparent conductive layer of a display panel according to further embodiments of the present disclosure. FIG. 43 is a schematic plan view of a first electrode layer of a display panel according to further embodiments of the present disclosure. FIG. 44 is a schematic plan view of a pixel defining layer of a display panel according to further embodiments of the present disclosure. FIG. 45 is an overall plan view of a pixel driving circuit and a first electrode layer, which are connected together, of a display panel according to further embodiments of the present disclosure. FIG. 46 is a cross-sectional view taken along a line C-C' of FIG. 41.

As shown in FIGS. 36 to 46, the control electrode T8_g of the eighth transistor T8 is electrically connected to the second luminescent control line EM2, and the second electrode of the eighth transistor T8 is electrically connected to the first electrode 201 of one of the plurality of light-emitting devices 20. An orthographic projection of the eighth transistor T8 on the base substrate 30 and an orthographic projection of the driving transistor T3 on the base substrate 30 are located on two opposite sides of an orthographic projection of the first luminescent control line EM1 on the base substrate 30, respectively.

As shown in FIG. 36, a semiconductor layer ACT is provided on the base substrate 30, a material of the semiconductor layer ACT in FIG. 36 is the same as that of the semiconductor layer ACT in FIG. 14, and a shape of the semiconductor layer ACT in FIG. 36 is similar to that of the semiconductor layer ACT in FIG. 14. Specifically, the semiconductor layer ACT in FIG. 36 includes active layers T1_a to T10_a of the transistors.

The second electrode T1_2 of the first transistor T1 and the second electrode T2_2 of the second transistor T2 have a one-piece structure. The first electrode T2_1 of the second transistor T2, the second electrode T3_2 of the driving transistor T3 and the first electrode T6_1 of the sixth transistor T6 have a one-piece structure. The second electrode T4_2 of the fourth transistor T4, the first electrode T3_1 of the driving transistor T3 and the second electrode T5_2 of the fifth transistor T5 have a one-piece structure. The first electrode T5_1 of the fifth transistor T5 and the first electrode T9_1 of the ninth transistor T9 have a one-piece structure. The second electrode T7_2 of the seventh transistor T7 and the second electrode T8_2 of the eighth transistor T8 have a one-piece structure. The first electrode T7_1 of the seventh transistor T7 and the first electrode T10_1 of the tenth transistor T10 have a one-piece structure. The active layer T7_a of the seventh transistor T7 and the active layer T10_a of the tenth transistor T10 are arranged in the first direction. The active layer T9_a of the ninth transistor T9 and the active layer T8_a of the eighth transistor T8 are arranged in the first direction.

As shown in FIG. 36, in one example, an active layer T1_a, the first electrode T1_1, and the second electrode T1_2 of the first transistor T1 are connected together so that the first transistor T1 has an L-shaped structure, including a first extension portion extending in the first direction and a second extension portion extending in the second direction, at least a portion of the first electrode T1_1 of the first transistor T1 is located on the first extension portion, and the second electrode T1_2 of the first transistor T1 is located on the second extension portion.

In one example, in every two adjacent pixel driving circuits in the same column, an active layer T7_a of the seventh transistor T7 and the active layer T10_a of the tenth transistor T10 in the previous pixel driving circuit and the active layer T1_a of the first transistor T1 in the next pixel driving circuit are arranged substantially in the first direction.

In one example, the first transistor T1 is located on a side of the driving transistor T3 away from the eighth transistor T8.

As shown in FIG. 46, a first gate insulating layer GI1 is disposed on a side of the semiconductor layer ACT away from the base substrate 30, and for the material of the first gate insulating layer GI1, reference is made to the description in the above embodiments and it is not described again here.

As shown in FIG. 37, a material of the first gate metal layer G1 is the same as that of the first gate metal layer G1 in FIG. 15, and a shape of the first gate metal layer G1 is similar to that of the first gate metal layer G1 in FIG. 15. A difference between the first gate metal layer G1 is the same as that of the first gate metal layer G1 in FIG. 15 is: in FIG. 37, the first gate metal layer G1 includes the control electrode T10_g of the tenth transistor T10 in addition to the control electrodes T1_g to T9_g of the first transistor T1 to the ninth transistor T9 and the first plate C11 of the storage capacitor Cst. In addition, the first gate metal layer G1 includes the first luminescent control line EM1 and the second luminescent control line EM2, and does not include the third luminescent control line EM3. As shown in FIG. 37, the first luminescent control line EM1 is located between the second luminescent control line EM2 and the first plate C11. Both the first transistor T1 and the second transistor T2 may be double-gate transistors. In the pixel driving circuits in any two adjacent rows, the control electrode T7_g of the seventh transistor T7 and the control electrode T10_g of the tenth transistor T10 in the pixel driving circuit in the previous row and one of the control electrodes T1_g of the first transistor T1 in the pixel driving circuit in the next row may have a one-piece structure.

As shown in FIG. 37, the control electrode T5_g of the fifth transistor T5, the control electrode T6_g of the sixth transistor T6, and the first luminescent control line EM1 have a one-piece structure. The control electrode T8_g of the eighth transistor T8, the control electrode T9_g of the ninth transistor T9 and the second luminescent control line EM2 have a one-piece structure.

As shown in FIG. 37, the first plate C11 of the storage capacitor Cst is shared with the control electrode T3_g of the driving transistor T3. The control electrode T2_g of the second transistor T2 and the control electrode T4_g of the fourth transistor T4 in the same pixel driving circuit may be separated from each other, and in every two adjacent pixel driving circuits in the same row, the control electrode T2_g of the second transistor T2 in one pixel driving circuit and the control electrode T4_g of the fourth transistor T4 in the other pixel driving circuit may have a one-piece structure.

As shown in FIG. 46, a second gate insulating layer GI2 is disposed on a side of the first gate metal layer G1 away from the base substrate 30, and for the material of the second gate insulating layer GI2, reference is made to the description in the above embodiments and it is not described again here.

As shown in FIG. 46, the second gate metal layer G2 is disposed on a side of the second gate insulating layer GI2 away from the base substrate 30, and as shown in FIG. 38, may include: the first initialization voltage line Vinit1, the second initialization voltage line Vinit2, and the second plate C12 of the storage capacitor Cst. The first initialization voltage line Vinit1 is located on a side of the second initialization voltage line Vinit2 away from the second plate C12, and may have a wavy structure extending in the first direction as a whole. The second initialization voltage line Vinit2 extends in the first direction as a whole, and includes a signal line body and a connection portion connected to the signal line body, the signal line body extends in the first direction, one end of the connection portion is connected to the signal line body, and the other end of the connection portion is connected to the first electrode T7_1 of the seventh transistor T7.

As shown in FIG. 46, an interlayer dielectric layer ILD is disposed on a side of the second gate metal layer G2 away from the base substrate 30, and for the material of the interlayer dielectric layer ILD, reference is made to the description in the above embodiments and it is not described again here.

As shown in FIG. 46, the first source-drain metal layer SD1 is disposed on a side of the interlayer dielectric layer ILD away from the base substrate 30. As shown in FIG. 39, the first source-drain metal layer SD1 includes: a first reset signal line Re1, a scan line GT, a first power supply sub-line Vdd1, a third adapter electrode E3, an eighth adapter electrode E8, a ninth adapter electrode E9, a tenth adapter electrode E10, an eleventh adapter electrode E11, a fourteenth adapter electrode E14, a fifteenth adapter electrode E15, and a sixteenth adapter electrode E16.

The first reset signal line Re1 extends in the first direction, and the scan line GT has a bent structure extending in the first direction as a whole. The first power supply sub-line Vdd1 may include a power supply line body Vdda extending in the first direction and a power supply line connection portion Vddb extending in the second direction, the power supply line connection portion Vddb and the power supply line body Vdda have a one-piece structure. The power supply line connection portion Vddb is electrically connected to the first electrode T5_1 of the fifth transistor T5 through a fifteenth via V15.

The first reset signal line Re1, the scan line GT, and the first power supply sub-line Vdd1 connected to the same pixel driving circuit are sequentially arranged in the second direction, the ninth adapter electrode E9 is located on a side of the first reset signal line Re1 away from the scan line GT, the eighth adapter electrode E8 and the fifteenth adapter electrode E15 are located between the scan line GT and the first reset signal line Re1, the sixteenth adapter electrode E16 is located between the scan line GT and the first power supply sub-line Vdd1, and the third adapter electrode E3 is located on a side of the first power supply sub-line Vdd1 away from the scan line GT.

As shown in FIG. 39, the scan line GT may have a bent structure and extend in the first direction as a whole, and is electrically connected to the control electrode T4_g of the fourth transistor T4 through a thirty-second via V32. In every two adjacent pixel driving circuits in the same row, the control electrode T4_g of the fourth transistor T4 of one pixel driving circuit and the control electrode T2_g of the second transistor T2 of the other pixel driving circuit have a one-piece structure. Therefore, the scan line GT is electrically connected to the control electrode T4_g of the fourth transistor T4, so that the control electrodes T4_g of the fourth transistors T4 and the control electrodes T2_g of the second transistors T2 of the plurality of pixel driving circuits in the same row may all be connected to the scan line GT.

As shown in FIG. 39, the first reset signal line Re1 is electrically connected to the control electrode T1_g of the first transistor T1 through a seventeenth via V17. The first power supply sub-line Vdd1 is electrically connected to the second plate C12 of the storage capacitor Cst through a thirty-fifth via V35.

As shown in FIG. 39, the third adapter electrode E3 is electrically connected to the second electrode of the eighth transistor T8 through a fourth via V4, and is connected to the first electrode 201 of one of the light-emitting devices 20.

As shown in FIG. 39, for the positions and the connection of the eighth adapter electrode E8 and the ninth adapter electrode E9, reference is made to the description in the above embodiments, and they are not repeated here.

As shown in FIG. 39, the tenth adapter electrode E10 is located on a side of the first power supply sub-line Vdd1 away from the scan line GT, and is electrically connected to the second electrode TS_2 of the fifth transistor T5 through a twenty-first via V21 and electrically connected to the second electrode T9_2 of the ninth transistor T9 through a twenty-second via V22, thereby realizing the electrical connection between the second electrode T5_2 of the fifth transistor T5 and the second electrode T9_2 of the ninth transistor T9.

As shown in FIG. 39, the eleventh adapter electrode E11 is located on the side of the first power supply sub-line Vdd1 away from the scan line GT, and is electrically connected to the first electrode T8_1 of the eighth transistor T8 through a twenty-third via V23 and electrically connected to the second electrode T3_2 of the driving transistor T3 through a twenty-fourth via V24, thereby realizing the electrical connection between the first electrode T8_1 of the eighth transistor T8 and the second electrode T3_2 of the driving transistor T3.

As shown in FIG. 39, the fourteenth adapter electrode E14 is electrically connected to the second electrode T6_2 of the sixth transistor T6 through a twenty-eighteenth via V28, and is electrically connected to the second electrode T7_2 of the seventh transistor T7 through a twenty-ninth via V29, thereby realizing the electrical connection between the second electrode T6_2 of the sixth transistor T6 and the second electrode T7_2 of the seventh transistor T7.

As shown in FIG. 39, the fifteenth adapter electrode E15 is configured to connect the data line DL and the first electrode T4_1 of the fourth transistor T4, so that a data signal is transmitted to the fourth transistor T4.

As shown in FIG. 39, the sixteenth adapter electrode E16 is electrically connected to the control electrode T3_g of the driving transistor T3 through a thirty-third via V33, and is electrically connected to the second electrode T2_2 of the second transistor T2 through a thirty-fourth via V34, thereby realizing the electrical connection between the control electrode T3_g of the driving transistor T3 and the second electrode T2_2 of the second transistor T2.

As shown in FIG. 46, an insulating spacer layer 60 is located on a side of the first source-drain metal layer SD1 away from the base substrate 30, and for the material of the insulating spacer layer 60, reference is made to the description in the above embodiments and it is not described again here.

As shown in FIG. 46, the second source-drain metal layer SD2 is located on a side of the insulating spacer layer 60 away from the base substrate 30, and for the material of the second source-drain metal layer SD2, reference is made to the description in the above embodiments and it is not described again here.

As shown in FIG. 40, the second source-drain metal layer SD2 may include: the data line DL, the first initialization voltage supply line V1a, the second initialization voltage supply line V2a, a second power supply sub-line Vdd2, and the second power supply line VSS. Each signal line extends in the second direction.

As shown in FIGS. 39 to 40, the second initialization voltage supply line V2a is electrically connected to the eighth adapter electrode E8 through a thirteenth via V13. The eighth adapter electrode E8 is electrically connected to the second initialization voltage line Vinit2 through the twelfth via V12, so that a voltage signal through the second initialization voltage supply line V2a may be transmitted to the second initialization voltage line Vinit2 by means of the eighth adapter electrode E8. In one example, as shown in FIG. 39, the plurality of eighth adapter electrodes E8 connected to the pixel driving circuits in the same row include the plurality of first-type adapter electrodes E81 and the plurality of second-type adapter electrodes E82, and an orthographic projection of the second initialization voltage supply line V2a on the base substrate 30 overlaps with an orthographic projection of the corresponding first-type adapter electrode E81 on the base substrate 30, so that the second initialization voltage supply line V2a is electrically connected to the corresponding first-type adapter electrode E81 through the thirteenth via V13. An orthographic projection of the second initialization voltage supply line V2a on the base substrate 30 may not overlap with an orthographic projection of the corresponding second-type adapter electrode E82 on the base substrate 30, and the second initialization voltage supply line V2a and the corresponding second-type adapter electrode E82 are not directly connected to each other.

As shown in FIGS. 39 to 40, the first initialization voltage supply line V1a is electrically connected to the ninth adapter electrode E9 through a twentieth via V20. The ninth adapter electrode E9 is electrically connected to the first initialization voltage line Vinit1 through a nineteenth via V19, so that a voltage signal through the first initialization voltage supply line V1a may be transmitted to the first initialization voltage line Vinit1 by means of the ninth adapter electrode E9. In one example, as shown in FIG. 39, the plurality of ninth adapter electrodes E9 connected to the same row of pixel driving circuits includes a plurality of third-type adapter electrodes E91 and a plurality of fourth-type adapter electrodes E92. An orthographic projection of the first initialization voltage supply line V1a on the base substrate 30 overlaps with an orthographic projection of the corresponding third-type adapter electrode E91 on the base substrate 30, so that the first initialization voltage supply line V1a is electrically connected to the corresponding third-type adapter electrode E91 through the twentieth via V20. An orthographic projection of the first initialization voltage supply line V1a on the base substrate 30 may not overlap with an orthographic projection of the corresponding fourth-type adapter electrode E92 on the base substrate 30, and the first initialization voltage supply line V1a and the corresponding fourth-type adapter electrode E92 are not directly connected to each other.

As shown in FIGS. 39 to 40, the first power supply line VDD includes a plurality of first power supply sub-lines Vdd1 and a plurality of second power supply sub-lines Vdd2, which are cross-connected to each other to form a mesh structure, so that a voltage drop of the first power supply line VDD can be reduced, which is beneficial to display uniformity.

In some embodiments, as shown in FIGS. 39 to 40, each second power supply sub-line Vdd2 is connected to the corresponding first power supply sub-line Vdd1 through a sixteenth via V16, and the first power supply sub-line Vdd1 is electrically connected to the first electrode of the fifth transistor T5 through the fifteenth via V15. For example, each second power supply sub-line Vdd2 is electrically connected to the power supply line body Vdda of the corresponding first power supply sub-line Vdd1 through a sixteenth via V16, and the power supply line connection portion Vddb of the first power supply sub-line Vdd1 is electrically connected to the first electrode T5_1 of the fifth transistor T5 through the fifteenth via V15.

In some embodiments, as shown in FIGS. 39 to 40, an orthographic projection of the second power supply sub-line Vdd2 on the base substrate 30 may overlap with an orthographic projection of an active layer of at least one transistor on the base substrate 30, so as to reduce a leakage current for the transistor due to the transistor being illuminated, and improve electrical characteristics of the transistor. For example, an orthographic projection of the second power supply sub-line Vdd2 on the base substrate 30 overlaps with an orthographic projection of the active layer T1_a of the first transistor T1 on the base substrate 30 and an orthographic projection of the active layer T3_a of the driving transistor T3 on the base substrate 30.

The second power supply line VSS is electrically connected to the second electrode of each light-emitting device 20. For example, the second electrode of the light-emitting device 20 extends to a peripheral region where the second electrode of the light-emitting device 20 is connected to the second power supply line VSS through a via.

In some embodiments, as shown in FIGS. 39 to 40, an orthographic projection of the data line DL on the base substrate 30 overlaps with an orthographic projection of the fifteenth adapter electrode E15 on the base substrate 30, the data line DL is electrically connected to the fifteenth adapter electrode E15 through a thirtieth via V30, and the fifteenth adapter electrode E15 is electrically connected to the first electrode T4_1 of the fourth transistor T4 through a thirty-first via V31.

In some embodiments, as shown in FIG. 40, a plurality of data lines DL includes a first data line DL1, a second data line DL2, and a third data line DL3, each column of pixel driving circuits is electrically connected to one data line DL, a first side of each data line DL is adjacent to the second power supply sub-line Vdd2, a second side of the first data line DL1 is adjacent to the first initialization voltage supply line V1a, a second side of the second data line DL2 is adjacent to the second power supply line VSS, and a second side of the third data line DL3 is adjacent to the second initialization voltage supply line V2a.

In some embodiments, as shown in FIGS. 39 to 41, an orthographic projection of each of the first initialization voltage supply line V1a, the second initialization voltage supply line V2a, and the second power supply line VSS on the base substrate 30 overlaps with an orthographic projection of the tenth adapter electrode E10 on the base substrate 30.

In some embodiments, as shown in FIG. 40, each data line DL includes a transmission portion DLb and a protruding portion DLa electrically connected to the fifteenth adapter electrode E15 through the thirtieth via V30, a diameter of the protruding portion DLa is greater than that of the transmission portion DLb, and each of the first initialization voltage supply line V1a, the second initialization voltage supply line V2a, the second power supply sub-line Vdd2, and the second power supply line VSS is provided with a bending structure at a position corresponding to the protruding portion DLa for bypassing the protruding portion DLa.

As shown in FIG. 40, the second source-drain metal layer SD2 further includes: the second adapter electrode E2 and a thirteenth adapter electrode E13, and the second adapter electrode E2 is electrically connected to the third adapter electrode E3 through a via. The thirteenth adapter electrode E13 is electrically connected to the fourteenth adapter electrode E14 through a twenty-seventh via V27, and the fourteenth adapter electrode E14 is electrically connected to the second electrode T6_2 of the sixth transistor T6 through the twenty-eighteenth via V28. The thirteenth adapter electrode E13 is connected to the first electrode 201 of the first light-emitting device 21, so that the first electrode 201 of the first light-emitting device 21 is electrically connected to the second electrode T6_2 of the sixth transistor T6.

As shown in FIG. 40, the first power supply sub-line Vdd1 includes a first recess Va and a second recess Vb at edges of the first power supply sub-line Vdd1 on two opposite sides, respectively, the second adapter electrode E2 is disposed in the first recess Va, and the thirteenth adapter electrode E13 is disposed in the second recess Vb.

A second planarization layer is disposed on a side of the second source-drain metal layer SD2 away from the base substrate 30, and for the material of the second planarization layer, reference is made to the description in the above embodiments and it is not described again here.

The transparent conductive layer TL is located on a side of the second planarization layer away from the base substrate 30, and for the material of the transparent conductive layer TL, reference is made to the description in the above embodiments and it is not described again here.

As shown in FIG. 42, the transparent conductive layer TL includes a plurality of first adapter electrodes E1 and a plurality of twelfth adapter electrodes E12. The first electrode 201 of one of the two light-emitting devices 20 connected to each pixel driving circuit is electrically connected to the corresponding first adapter electrode E1, and the first electrode 201 of the other light-emitting device 20 is electrically connected to the corresponding fifth adapter electrode E5.

A third planarization layer is disposed on a side of the transparent conductive layer TL away from the base substrate 30, and for the material of the third planarization layer, reference is made to the description in the above embodiments and it is not described again here.

As shown in FIG. 43, the first electrode layer AND1 is disposed on a side of the third planarization layer away from the base substrate 30, and may be made of a transparent material such as indium tin oxide (ITO), indium zinc oxide (IZO) or the like.

The first electrode layer AND1 includes the first electrode 201 of each light-emitting device 20. As shown in FIGS. 36 to 46, in the two light-emitting devices 20 connected to each pixel driving circuit, the first electrode 201 of one light-emitting device 20 is electrically connected to the first adapter electrode E1 through a first via V1, the first adapter electrode E1 is electrically connected to the second adapter electrode E2 through a second via V2, the second adapter electrode E2 is electrically connected to the third adapter electrode E3 through a third via V3, and the third adapter electrode E3 is electrically connected to the second electrode of the eighth transistor T8 through a fourth via V4, so that the first electrode 201 of the one light-emitting device 20 is electrically connected to the second electrode T8_2 of the eighth transistor T8 through the first adapter electrode E1, the second adapter electrode E2 and the third adapter electrode E3. For example, in FIGS. 36 to 46, the electrical connection between the first electrode 201 of the second light-emitting device 22 and the second electrode T8_2 of the eighth transistor T8 is achieved through the first adapter electrode E1, the second adapter electrode E2 and the third adapter electrode E3.

As shown in FIGS. 36 to 46, the first electrode 201 of the first light-emitting device is electrically connected to the twelfth adapter electrode E12 through a twenty-fifth via V25, the twelfth adapter electrode E12 is electrically connected to the thirteenth adapter electrode E13 through a twenty-sixth via V26, the thirteenth adapter electrode E13 is electrically connected to the fourteenth adapter electrode E14 through the twenty-seventh via V27, and the fourteenth adapter electrode E14 is electrically connected to the second electrode T6_2 of the sixth transistor T6 through the twenty-eighteenth via V28. The electrical connection between the first light-emitting device 21 and the second electrode T6_2 of the sixth transistor T6 is achieved through the twelfth adapter electrode E12, the thirteenth adapter electrode E13 and the fourteenth adapter electrode E14.

The display panel further includes the pixel defining layer PDL located on a side of the first electrodes 201 of the light-emitting devices 20 away from the base substrate 30. The pixel defining layer PDL has pixel openings Pv therein, each pixel opening Pv exposes at least a portion of the corresponding first electrode 201, and a luminescent functional layer of each light-emitting device 20 is at least partially located in the corresponding pixel opening Pv. Each of some of the light-emitting devices 20 connected to the pixel driving circuit corresponds to pixel openings Pv, and each of the remaining light-emitting devices 20 corresponds to one pixel opening Pv. For example, the first light-emitting device 21 corresponds to one pixel opening Pv, and the second light-emitting device 22 corresponds to two pixel openings Pv.

The luminescent functional layer may include a luminescent layer, which may be made of a small molecule organic material or a polymer molecule organic material, may be made of a fluorescent luminescent material or a phosphorescent luminescent material, may emit red light, green light, blue light, or white light. Further, the luminescent functional layer may further include a hole injection layer, a hole transport layer, an electron injection layer, and an electron transport layer, and the like, as necessary.

In one example, the light-emitting devices 20 connected to the same pixel driving circuit emit light of the same color, e.g., red, green, blue or white. The plurality of light-emitting devices 20 of the display panel are divided into a plurality of repeating units, each of which includes light-emitting devices 20 connected to a plurality of pixel driving circuits. For example, each repeating unit includes light-emitting devices 20 connected to three pixel driving circuits. The light-emitting devices 20 connected to the three pixel driving circuits emit red light, green light, and blue light, respectively.

It should be understood that the above embodiments are merely exemplary embodiments adopted to explain the principles of the present disclosure, and the present disclosure is not limited thereto. It will be apparent to one of ordinary skill in the art that various changes and modifications may be made therein without departing from the spirit and scope of the present disclosure, and such changes and modifications also fall within the scope of the present disclosure.

**Claims**

1. A pixel driving circuit, comprising: a driving transistor, a first reset sub-circuit, a second reset sub-circuit, a luminescent control sub-circuit, a data writing sub-circuit, a gating sub-circuit and an energy storage element; wherein the energy storage element is connected between a control electrode and a first electrode of the driving transistor; wherein

   the first reset sub-circuit is configured to write a first initialization voltage signal to the control electrode of the driving transistor in response to a first reset signal;
   the second reset sub-circuit is configured to write a second initialization voltage signal to a first electrode of at least one of a plurality of light-emitting devices in response to a second reset signal;
   the data writing sub-circuit is configured to write a data voltage signal and a threshold voltage signal of the driving transistor to the energy storage element in response to a scan signal;
   the luminescent control sub-circuit is configured to electrically connect a first power supply line to the first electrode of the driving transistor in response to one of a first luminescent control signal and a second luminescent control signal; and
   the gating sub-circuit is configured to electrically connect a second electrode of the driving transistor to different light-emitting devices in response to different luminescent control signals.

2. The pixel driving circuit of claim 1, wherein the luminescent control sub-circuit comprises:
   a fifth transistor, wherein a control electrode of the fifth transistor is electrically connected to a first luminescent control line, a first electrode of the fifth transistor is electrically connected to the first power supply line, and a second electrode of the fifth transistor is electrically connected to the first electrode of the driving transistor.

3. The pixel driving circuit of claim 2, wherein the gating sub-circuit comprises: a sixth transistor, an eighth transistor, and a ninth transistor, wherein

   a control electrode of the sixth transistor is electrically connected to the first luminescent control line, and a first electrode of the sixth transistor is electrically connected to the second electrode of the driving transistor;
   a control electrode of the eighth transistor is electrically connected to a second luminescent control line, a first electrode of the eighth transistor is electrically connected to a second electrode of the sixth transistor, and a second electrode of the eighth transistor is electrically connected to a first light-emitting device; and
   a control electrode of the ninth transistor is electrically connected to a third luminescent control line, a first electrode of the ninth transistor is electrically connected to the second electrode of the sixth transistor, and a second electrode of the ninth transistor is electrically connected to a second light-emitting device.

4. The pixel driving circuit of claim 1, wherein the luminescent control sub-circuit comprises: a fifth transistor and a ninth transistor;

   a control electrode of the fifth transistor is electrically connected to a first luminescent control line, a first electrode of the fifth transistor is electrically connected to the first power supply line, and a second electrode of the fifth transistor is electrically connected to the first electrode of the driving transistor; and
   a control electrode of the ninth transistor is electrically connected to a second luminescent control line, a first electrode of the ninth transistor is electrically connected to the first power supply line, and a second electrode of the ninth transistor is electrically connected to the first electrode of the driving transistor.

5. The pixel driving circuit of claim 4, wherein the gating sub-circuit comprises: a sixth transistor and an eighth transistor; wherein

a control electrode of the sixth transistor is electrically connected to the first luminescent control line, a first electrode of the sixth transistor is electrically connected to the second electrode of the driving transistor, and a second electrode of the sixth transistor is electrically connected to a first light-emitting device; and
a control electrode of the eighth transistor is electrically connected to the second luminescent control line, a first electrode of the eighth transistor is electrically connected to the second electrode of the driving transistor, and a second electrode of the eighth transistor is electrically connected to a second light-emitting device.

6. The pixel driving circuit of any one of claims 1 to 5, wherein the first reset sub-circuit comprises: a first transistor, a control electrode of the first transistor is electrically connected to a first reset signal line, a first electrode of the first transistor is electrically connected to a first initialization voltage line, and a second electrode of the first transistor is electrically connected to the control electrode of the driving transistor.

7. The pixel driving circuit of any one of claims 1 to 5, wherein the second reset sub-circuit comprises: a seventh transistor, a control electrode of the seventh transistor is electrically connected to a second reset signal line, a first electrode of the seventh transistor is electrically connected to a second initialization voltage line, and a second electrode of the seventh transistor is electrically connected to a first electrode of a first light-emitting device.

8. The pixel driving circuit of claim 7, wherein the second reset sub-circuit further comprises: a tenth transistor, a control electrode of the tenth transistor is electrically connected to the second reset signal line, a first electrode of the tenth transistor is electrically connected to the second initialization voltage line, and a second electrode of the tenth transistor is electrically connected to a first electrode of a second light-emitting device.

9. The pixel driving circuit of any one of claims 1 to 5, wherein the data writing sub-circuit comprises: a fourth transistor and a second transistor;

a control electrode of the fourth transistor is electrically connected to a scan line, a first electrode of the fourth transistor is electrically connected to a data line, and a second electrode of the fourth transistor is electrically connected to the first electrode of the driving transistor; and
a control electrode of the second transistor is electrically connected to the scan line, a first electrode of the second transistor is electrically connected to the second electrode of the driving transistor, and a second electrode of the second transistor is electrically connected to the control electrode of the driving transistor.

10. The pixel driving circuit of any one of claims 1 to 5, wherein the energy storage element comprises a storage capacitor comprising a first plate electrically connected to the control electrode of the driving transistor and a second plate electrically connected to the first electrode of the driving transistor.

11. A driving method for the pixel driving circuit of any one of claims 1 to 10, comprising a plurality of operating phases, wherein

in a reset sub-phase of each operating phase, the driving method comprises writing, by the first reset sub-circuit, the first initialization voltage signal to the control electrode of the driving transistor in response to the first reset signal;
in a data writing sub-phase of each operating phase, the driving method comprises writing, by the second reset sub-circuit, the second initialization voltage signal to the first electrode of at least one of the plurality of light-emitting devices in response to the second reset signal; and writing, by the data writing sub-circuit, the data voltage signal and the threshold voltage signal of the driving transistor to the energy storage element in response to the scan signal; and
in a luminescent sub-phase of each operating phase, the driving method comprises electrically connecting, by the luminescent control sub-circuit, the first power supply line to the first electrode of the driving transistor in response to one of the first luminescent control signal and the second luminescent control signal; and in luminescent sub-phases of different operating phases, the driving method comprises electrically connecting, by the gating sub-circuit, the second electrode of the driving transistor to different light-emitting devices in response to different luminescent control signals.

12. A display panel, comprising: a base substrate and a plurality of pixel driving circuits on the base substrate, wherein each of the plurality of pixel driving circuits is electrically connected to a plurality of light-emitting devices, and each pixel driving circuit comprises: a driving transistor, a luminescent control sub-circuit, and a gating sub-circuit; wherein

the luminescent control sub-circuit is configured to electrically connect a first power supply line to a first electrode of the driving transistor in response to one of a first luminescent control signal through a first luminescent control line and a second luminescent control signal through a second luminescent control line; and
the gating sub-circuit is configured to electrically connect a second electrode of the driving transistor to different light-emitting devices in response to different luminescent control signals;
wherein the gating sub-circuit comprises: an eighth transistor, a control electrode of the eighth transistor is electrically connected to the second luminescent control line, a second electrode of the eighth transistor is electrically connected to a first electrode of one of the plurality of light-emitting devices, and an orthographic projection of the eighth transistor on the base substrate and an orthographic projection of the driving transistor on the base substrate are on two opposite sides of an orthographic projection of the first luminescent control line on the base substrate, respectively.

13. The display panel of claim 12, wherein the display panel further comprises: a first adapter electrode, a second adapter electrode and a third adapter electrode, a first electrode of one of the plurality of light-emitting devices connected to each pixel driving circuit is electrically connected to the first adapter electrode through a first via, the first adapter electrode is electrically connected to the second adapter electrode through a second via, the second adapter electrode is electrically connected to the third adapter electrode through a third via, and the third adapter electrode is electrically connected to the second electrode of the eighth transistor through a fourth via.

14. The display panel of claim 13, wherein the display panel comprises a semiconductor layer, a first gate metal layer, a first source-drain metal layer, a second source-drain metal layer and a transparent conductive layer which are sequentially arranged in a direction away from the base substrate, the second electrode of the eighth transistor is in the semiconductor layer, the first luminescent control line and the second luminescent control line are in the first gate metal layer, the first adapter electrode is in the transparent conductive layer, the second adapter electrode is in the second source-drain metal layer, and the third adapter electrode is in the first source-drain metal layer.

15. The display panel of claim 12, wherein the plurality of light-emitting devices comprises a first light-emitting device and a second light-emitting device, the second electrode of the eighth transistor is electrically connected to the first light-emitting device, and the gating sub-circuit further comprises: a sixth transistor and a ninth transistor;

wherein a control electrode of the sixth transistor is electrically connected to the first luminescent control line, a first electrode of the sixth transistor is electrically connected to the second electrode of the driving transistor, and a second electrode of the sixth transistor is electrically connected to a first electrode of the eighth transistor;
a control electrode of the ninth transistor is electrically connected to a third luminescent control line, a first electrode of the ninth transistor is electrically connected to the second electrode of the sixth transistor, and a second electrode of the ninth transistor is electrically connected to the second light-emitting device; and
the first luminescent control line, the third luminescent control line and the second luminescent control line are arranged in a same layer and are sequentially arranged along a direction away from the driving transistor.

16. The display panel of claim 15, wherein the display panel further comprises: a fourth adapter electrode electrically connected to the first electrode of the eighth transistor through a fifth via and electrically connected to the second electrode of the sixth transistor through a sixth via.

17. The display panel of claim 16, wherein the display panel comprises a semiconductor layer, a first gate metal layer, and a first source-drain metal layer, which are sequentially arranged in a direction away from the base substrate, the first luminescent control line and the second luminescent control line are in the first gate metal layer, the first electrode of the eighth transistor and the second electrode of the sixth transistor are in the semiconductor layer, and the fourth adapter electrode is in the first source-drain metal layer.

18. The display panel of claim 15, wherein the display panel further comprises: a fifth adapter electrode, a sixth adapter electrode and a seventh adapter electrode; wherein
a first electrode of the second light-emitting device is electrically connected to the fifth adapter electrode through a seventh via, the fifth adapter electrode is electrically connected to the sixth adapter electrode through an eighth via, the sixth adapter electrode is electrically connected to the seventh adapter electrode through a ninth via, and the seventh adapter electrode is electrically connected to the second electrode of the ninth transistor through a tenth via.

19. The display panel of claim 15, wherein each pixel driving circuit further comprises a second reset sub-circuit comprising a seventh transistor, a control electrode of the seventh transistor is electrically connected to a second reset signal line, a first electrode of the seventh transistor is electrically connected to a second initialization voltage line, and a second electrode of the seventh transistor is electrically connected to a first electrode of the first light-emitting device.

20. The display panel of claim 19, wherein the display panel further comprises: an eighth adapter electrode electrically connected to the first electrode of the seventh transistor through an eleventh via and electrically connected to the second initialization voltage line through a twelfth via.

21. The display panel of claim 20, wherein the second initialization voltage line extends in a first direction, and the display panel further comprises: a second initialization voltage supply line extending in a second direction and electrically connected to the eighth adapter electrode through a thirteenth via;

the plurality of pixel driving circuits are arranged in a plurality of columns along the first direction and in a plurality of rows along the second direction, and the display panel comprises a plurality of the second initialization voltage supply lines arranged in the first direction; and
a plurality of eighth adapter electrodes connected to pixel driving circuits in the same row comprise a plurality of first-type adapter electrodes and a plurality of second-type adapter electrodes, wherein the plurality of first-type adapter electrodes are electrically connected to the corresponding second initialization voltage supply line, orthographic projections of the plurality of first-type adapter electrodes on the base substrate and an orthographic projection of the corresponding second initialization voltage supply line on the base substrate overlap with each other, orthographic projections of the plurality of second-type adapter electrodes on the base substrate and orthographic projections of the plurality of second initialization voltage supply lines on the base substrate do not overlap with each other, and at least one second-type adapter electrode is arranged between every two adjacent first-type adapter electrodes arranged along the first direction.

22. The display panel of claim 21, wherein the display panel comprises a semiconductor layer, a first gate metal layer, a second gate metal layer, a first source-drain metal layer and a second source-drain metal layer, which are sequentially arranged in a direction away from the base substrate; wherein
the first electrode of the seventh transistor is in the semiconductor layer, the first luminescent control line and the second luminescent control line are in the first gate metal layer, the second initialization voltage line is in the second gate metal layer, the plurality of eighth adapter electrodes are in the first source-drain metal layer, and the plurality of second initialization voltage supply lines are in the second source-drain metal layer.

23. The display panel of claim 19, wherein the second reset sub-circuit further comprises: a tenth transistor, a control electrode of the tenth transistor is electrically connected to the second reset signal line, a first electrode of the tenth transistor is electrically connected to the second initialization voltage line, and a second electrode of the tenth transistor is electrically connected to a first electrode of the second light-emitting device.

24. The display panel of claim 23, wherein the display panel further comprises: a seventh adapter electrode electrically connected to the second electrode of the ninth transistor through a tenth via and electrically connected to the second electrode of the tenth transistor through a fourteenth via.

25. The display panel of claim 15, wherein the luminescent control sub-circuit comprises: a fifth transistor, a control electrode of the fifth transistor is electrically connected to the first luminescent control line, a first electrode of the fifth transistor is electrically connected to the first power supply line, and a second electrode of the fifth transistor is electrically connected to the first electrode of the driving transistor.

26. The display panel of claim 25, wherein the first power supply line comprises: a first power supply sub-line and a second power supply sub-line, the first power supply sub-line is electrically connected to the first electrode of the fifth transistor through a fifteenth via, and the second power supply sub-line is connected to the first power supply sub-line through a sixteenth via; and
the display panel comprises a plurality of first power supply sub-lines and a plurality of second power supply sub-lines, which are cross-connected to each other to form a mesh structure.

27. The display panel of any one of claims 12 to 26, wherein each pixel driving circuit further comprises a first reset sub-circuit comprising: a first transistor, a control electrode of the first transistor is electrically connected to a first reset signal line, a first electrode of the first transistor is electrically connected to a first initialization voltage line, and a second electrode of the first transistor is electrically connected to the control electrode of the driving transistor; wherein the first transistor is on a side of the driving transistor away from the eighth transistor;

each pixel driving circuit further comprises a second reset sub-circuit comprising: a seventh transistor, and a control electrode of the seventh transistor is electrically connected to a second reset signal line; and
the plurality of pixel driving circuits are arranged in a plurality of columns along a first direction and arranged in a plurality of rows along a second direction, and in the pixel driving circuits in any two adjacent rows, the second reset signal line connected to the seventh transistors in the previous row and the first reset signal line in the next row have a one-piece structure.

28. The display panel of claim 27, wherein an active layer, the first electrode, and the second electrode of the first transistor are connected together so that the first transistor has an L-shaped structure, comprising a first extension portion extending in the first direction and a second extension portion extending in the second direction, at least a portion of the first electrode of the first transistor is on the first extension portion, and the second electrode of the first transistor is on the second extension portion.

29. The display panel of claim 27, wherein the display panel further comprises: a ninth adapter electrode electrically connected to the first electrode of the first transistor through an eighteenth via and electrically connected to the first initialization voltage line through a nineteenth via.

30. The display panel of claim 29, wherein the first initialization voltage line extends in the first direction; and
the display panel further comprises: a first initialization voltage supply line extending in the second direction, the second direction intersects with the first direction, and the first initialization voltage supply line is electrically connected to the ninth adapter electrode through a twentieth via.

31. The display panel of claim 30, wherein the plurality of pixel driving circuits are arranged in the plurality of columns along the first direction and in the plurality of rows along the second direction, and the display panel comprises a plurality of the first initialization voltage supply lines arranged in the first direction; and
ninth adapter electrodes connected to pixel driving circuits in a same row comprise a plurality of third-type adapter electrodes and a plurality of fourth-type adapter electrodes, wherein one of the plurality of third-type adapter electrodes is electrically connected to a corresponding first initialization voltage supply line, an orthographic projection of the third-type adapter electrode on the base substrate and an orthographic projection of the corresponding first initialization voltage supply line on the base substrate overlap with each other, orthographic projections of the plurality of fourth-type adapter electrodes on the base substrate and orthographic projections of the plurality of first initialization voltage supply lines on the base substrate do not overlap with each other, and at least one fourth-type adapter electrode is arranged between every two adjacent third-type adapter electrodes arranged along the first direction.

32. The display panel of claim 30, wherein the display panel comprises a semiconductor layer, a first gate metal layer, a second gate metal layer, a first source-drain metal layer and a second source-drain metal layer, which are sequentially arranged in a direction away from the base substrate; wherein
the control electrode of the first transistor is in the first gate metal layer, the first electrode of the first transistor is in the semiconductor layer, the first luminescent control line and the second luminescent control line are in the first gate metal layer, the first initialization voltage line is in the second gate metal layer, the ninth adapter electrode is in the first source-drain metal layer, the first initialization voltage supply line is in the second source-drain metal layer, and the first reset signal line is in the first source-drain metal layer and is electrically connected to the control electrode of the first transistor through a seventeenth via.

33. The display panel of any one of claims 12 to 26, wherein each pixel driving circuit further comprises a data writing sub-circuit comprising: a fourth transistor and a second transistor;

a control electrode of the fourth transistor is electrically connected to a scan line, a first electrode of the fourth transistor is electrically connected to a data line, and a second electrode of the fourth transistor is electrically connected to the first electrode of the driving transistor; and
a control electrode of the second transistor is electrically connected to the scan line, a first electrode of the second transistor is electrically connected to the second electrode of the driving transistor, and a second electrode of the second transistor is electrically connected to the control electrode of the driving transistor.

34. The display panel of claim 33, wherein the display panel comprises: a first gate metal layer and a first source-drain metal layer, and the first source-drain metal layer is on a side of the first gate metal layer away from the base substrate;

the control electrode of the second transistor and the control electrode of the fourth transistor are in the first gate metal layer, and in any two adjacent pixel driving circuits in the first direction, the control electrode of the second transistor of one pixel driving circuit and the control electrode of the fourth transistor of the other pixel driving circuit have a one-piece structure; and
the scan line is in the first source-drain metal layer and is electrically connected to the control electrode of the fourth transistor through a thirty-second via.

35. The display panel of claim 33, wherein each pixel driving circuit further comprises a storage capacitor, the storage capacitor comprises a first plate and a second plate opposite to each other, the first plate and the control electrode of the driving transistor have a one-piece structure, and the first power supply line is electrically connected to the second plate through a thirty-fifth via; and
the display panel further comprises: a sixteenth adapter electrode electrically connected to the control electrode of the driving transistor through a thirty-third via and electrically connected to the second electrode of the second transistor through a thirty-fourth via.

36. The display panel of claim 35, wherein the second plate has an avoidance notch so that an orthographic projection of the second plate on the base substrate does not overlap with an orthographic projection of the thirty-third via on the base substrate.

37. The display panel of any one of claims 12 to 26, wherein the plurality of pixel driving circuits are arranged in a plurality of columns in a first direction and are arranged in a plurality of rows in a second direction;

the display panel comprises a plurality of data lines, a plurality of first initialization voltage supply lines, a plurality of second initialization voltage supply lines, a plurality of second power supply lines and a plurality of second power supply sub-lines in a same layer, second electrodes of the plurality of light-emitting devices are electrically connected to the plurality of second power supply lines, respectively, and the plurality of data lines, the plurality of first initialization voltage supply lines, the plurality of second initialization voltage supply lines, the plurality of second power supply lines and the plurality of second power supply sub-lines extend in a second direction; and
the plurality of data lines comprise a first data line, a second data line and a third data line, pixel driving circuits in each column are electrically connected to one corresponding data line, a first side of each data line is adjacent to a corresponding second power supply sub-line, a second side of the first data line is adjacent to a corresponding first initialization voltage supply line, a second side of the second data line is adjacent to a corresponding second power supply line, and a second side of the third data line is adjacent to a corresponding second initialization voltage supply line.

38. The display panel of any one of claims 12 to 26, wherein the display panel further comprises a pixel defining layer on a side of first electrodes of the plurality of light-emitting devices away from the base substrate, the pixel defining layer has pixel openings therein, each pixel opening exposes at least a portion of a corresponding first electrode, and a luminescent functional layer of each light-emitting device is at least partially located in a corresponding pixel opening; and
each of some of the plurality of light-emitting devices connected to each pixel driving circuit corresponds to multiple pixel openings, and each of the remaining light-emitting devices connected to each pixel driving circuit corresponds to one pixel opening.

VDD

103    105

Energy
storage
element

Luminescent
control sub-circuit  ── EM1

104

Data
writing
sub-circuit    N1         T3

First reset
sub-circuit

101

106    102

Gating sub-
circuit

Second
reset sub-
circuit

21(20)          22(20)

VSS    VSS

FIG. 1

L viewing angle

R viewing angle

BM

41

40
10

30              20              20              20

FIG. 2

Display at          Display at          Display at          Display at          Display at          Display at
small viewing     large viewing     small viewing     large viewing     small viewing     large viewing
angle              angle              angle              angle              angle              angle

BM

41

40

10

30    20    20    20    20    20    20

FIG. 3

FIG. 4

FIG. 5

FIG. 6

First operating phase     Second operating phase

Re1

Re2

GT

EM1

EM3

EM2

**FIG. 7**

VDD

105

103

Cst

T5   EM1

N1

T4   DL

T3

GT

104

T2

GT

Re1   T1

101   Vinit1

106

T6   EM1

N4

EM2   T8     T9   EM3

T7   T10

21(20)     22(20)

VSS   Re2   Re2   VSS

102   Vinit2

**FIG. 8**

First operating phase    Second operating phase

Re1

Re2

GT

EM1

EM3

EM2

FIG. 9

VDD

103        105
Cst    T5 ⊢ EM1
              T4 ⊢ DL
N1         T3    GT    104
        T2
Re1 ⊢ T1    GT
101  Vinit1                    106

EM1 ⊢ T6            T8 ⊢ EM2

21(20)    T7    T10    22(20)
VSS    Re2    Re2    VSS
102    Vinit2

FIG. 10

t1  t2    t3

Re1

Re2

GT

EM1

EM2

FIG. 11

FIG. 12

FIG. 13

ACT:

FIG. 14

G1:

FIG. 15

G2:

Vinit1

Vinit2 {
Vinit21
Vinit22
}

H0

C12

First direction

Second direction

FIG. 16

SD1:

E91/E9

E92/E9

E82/E8

E81/E8

V19

V19

V18

V18

V17

V11

V12

Re1

V11

E15

V12

V31

GT

V32

E16

V34

V35

V33

Vdda
Vddb } Vdd1

V15

V6

E7

E4

V10

V5

V4

E3

First direction

Second direction

FIG. 17

SD2:

DL1/DL

DL2/DL

DL3/DL

V20

Vdd2

VSS

V2a

V1a

V30

DLa

DLb

V16

E6

Vb

V9

V20

V3

E2

V13

Va

First direction

Second direction

FIG. 18

FIG. 19

TL:

FIG. 20

AND1:

FIG. 21

FIG. 22

FIG. 23

PLN3

E1/TL

PLN2

V2

E2/SD2

V3

E3/SD1

ILD

GI2

60

V4

GI1

ACT

30

EM2

**FIG. 24**

ACT：

T1_1

T7_a

T10_2

T10_a

T7_2

T7_a

T1_a

T7_1/
T10_1

T1_2/T2_2

T4_1

T4_a

T2_a

T3_a

T3_a

T3_1/T4_2/T5_2

T3_2/T6_1

T5_a

T6_a

T5_1

T9_1/T6_2

T8_1

T9_a

T8_a

T9_2

T7_2/T8_2

T7_a

First
direction

Second
direction

**FIG. 25**

FIG. 26

FIG. 27

SD1:

FIG. 28

FIG. 29

FIG. 30

TL:

FIG. 31

AND1:

FIG. 32

FIG. 33

FIG. 34

SD2 →

E6

V9

Vdd2

60

E7/SD1

ILD

GI2

V10

V14

GI1

ACT

30  T9_1  T9_a  EM3  T9_2  EM2  T7_2

**FIG. 35**

ACT:

T1_1  T7_a

T10_a  T10_2  T7_2

T7_a

T1_a

T1_2/T2_2

T4_1

T4_a

T3_a

T3_1/T4_2/T5_2

T7_1/
T10_1

T2_a

T3_a

T3_2/T6_1

T5_a  T6_a

T5_1/T9_1

T9_a

T9_2

T6_a

T8_1

T8_a

T8_2

T10_a

First direction

Second
direction

**FIG. 36**

G1:

T7_g
T4_g
T2_g
T1_g

C11/
T3_g

T5_g

EM1

T6_g

EM2

T9_g
T8_g

First
direction

Second
direction

FIG. 37

G2:

Vinit1

Vinit2
{ Vinit21
Vinit22

H0

C12

First direction

Second
direction

FIG. 38

SD1:

FIG. 39

FIG. 40

ACT+G1+G2+SD1+SD2:

FIG. 41

FIG. 42

AND1:

FIG. 43

PDL

Pv

FIG. 44

FIG. 45

FIG. 46

## INTERNATIONAL SEARCH REPORT

| | International application No. |
|---|---|
| | **PCT/CN2024/103891** |

| A. | CLASSIFICATION OF SUBJECT MATTER |
|---|---|

G09G3/34(2006.01)i; G09G3/32(2016.01)i; G09F9/33(2006.01)i; G02F1/13357(2006.01)i

According to International Patent Classification (IPC) or to both national classification and IPC

| B. | FIELDS SEARCHED |
|---|---|

Minimum documentation searched (classification system followed by classification symbols)

IPC:G09G G09F G02F

Documentation searched other than minimum documentation to the extent that such documents are included in the fields searched

Electronic data base consulted during the international search (name of data base and, where practicable, search terms used)

CNABS; CNTXT; CNKI; VEN; WOTXT; USTXT; EPTXT: 像素, 驱动, 电路, 晶体管, 复位, 重置, 初始化, 选通, 面板, 基板, 投影, 两侧, 相对, pixel, driv+, transistor, reset, initial, gat+, emit, oled, panel, substrate, orthographic projection, side+, relative

| C. | DOCUMENTS CONSIDERED TO BE RELEVANT |
|---|---|

| Category* | Citation of document, with indication, where appropriate, of the relevant passages | Relevant to claim No. |
|---|---|---|
| X | CN 115831006 A (SHANGHAI TIANMA MICROELECTRONICS CO., LTD.) 21 March 2023 (2023-03-21) description, paragraphs [0054]-[0167], and figures 1-32 | 1-11 |
| Y | CN 103000131 A (BOE TECHNOLOGY GROUP CO., LTD.) 27 March 2013 (2013-03-27) description, paragraphs [0038]-[0107], and figures 2-8 | 1-11 |
| Y | CN 108230982 A (BOE TECHNOLOGY GROUP CO., LTD.) 29 June 2018 (2018-06-29) description, paragraphs [0052]-[0097], and figures 1-6 | 1-11 |
| Y | CN 101075410 A (TOPPOLY OPTOELECTRONICS CORP.) 21 November 2007 (2007-11-21) description, page 4, line 6-page 10, line 14, and figures 2-10 | 1-11 |
| Y | WO 2022226785 A1 (BOE TECHNOLOGY GROUP CO., LTD.) 03 November 2022 (2022-11-03) description, page 8, line 5-page 21, line 11, and figures 2-16 | 1-11 |
| A | WO 2021016946 A1 (BOE TECHNOLOGY GROUP CO., LTD.) 04 February 2021 (2021-02-04) entire document | 1-38 |

☑ Further documents are listed in the continuation of Box C.    ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **04 September 2024** | **29 September 2024** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
| --- |
| **PCT/CN2024/103891** |

| C. | DOCUMENTS CONSIDERED TO BE RELEVANT | |
| --- | --- | --- |
| Category* | Citation of document, with indication, where appropriate, of the relevant passages | Relevant to claim No. |
| A | WO 2023050057 A1 (BOE TECHNOLOGY GROUP CO., LTD. et al.) 06 April 2023 (2023-04-06)<br>entire document | 1-38 |

Form PCT/ISA/210 (second sheet) (July 2022)

INTERNATIONAL SEARCH REPORT
Information on patent family members

International application No.

**PCT/CN2024/103891**

| Patent document cited in search report | | | Publication date (day/month/year) | Patent family member(s) | | | Publication date (day/month/year) |
|---|---|---|---|---|---|---|---|
| CN | 115831006 | A | 21 March 2023 | None | | | |
| CN | 103000131 | A | 27 March 2013 | None | | | |
| CN | 108230982 | A | 29 June 2018 | None | | | |
| CN | 101075410 | A | 21 November 2007 | CN | 101075410 | B | 18 July 2012 |
| WO | 2022226785 | A1 | 03 November 2022 | None | | | |
| WO | 2021016946 | A1 | 04 February 2021 | None | | | |
| WO | 2023050057 | A1 | 06 April 2023 | None | | | |

Form PCT/ISA/210 (patent family annex) (July 2022)